# EUROPEAN PATENT APPLICATION

(11) **EP 2 392 528 A1**
(43) Date of publication of application: **07.12.2011**
(21) Application number: 10735688.3
(22) Date of filing: 08.01.2010
(51) Int. Cl.: B65H 23/025, B65H 23/038, H01L 21/205, H01L 31/04

(54) **POSITION CONTROLLER FOR FLEXIBLE SUBSTRATE**

(30) Priority: 28.01.2009 JP 2009016440
(71) Applicant: Fuji Electric Co., Ltd., Kawasaki-shi 210-9530 (JP)
(72) Inventor: YOKOYAMA, Shoji, Kawasaki-shi 210-9530 (JP); YAMADA, Takanori, Kawasaki-shi 210-9530 (JP); WADA, Takenori, Kawasaki-shi 210-9530 (JP)
(74) Representative: MERH-IP Matias Erny Reichl Hoffmann
(86) International application number: PCT/JP2010/050140
(87) International publication number: WO 2010/087218

(57) **Abstract**

A flexible substrate position control device (100) in a processing device, which transports a band-shaped flexible substrate (1) in a horizontal direction and in a vertical orientation and carries out processing of the substrate by processing units installed in a transport path of the substrate, is provided with: a pair of clamping rollers (131,132) that clamp an upper edge of the substrate; a support mechanism (140) that rotatably supports the pair of clamping rollers while allowing these rollers to mutually contact and separate from each other; urging means (150) for applying pressing force to the pair of clamping rollers through the support mechanism; and adjusting means (160) for adjusting the pressing force applied by the urging means. The pair of clamping rollers has an inclination, in which the direction of pressing relative to the clamping surface of the substrate is towards the edge of the substrate in the width direction, and is supported such that the rotating direction at the clamping surface is the same direction as the transport direction of the substrate. This flexible substrate position control device is able to inhibit the occurrence of sagging and wrinkling of a band-shaped flexible substrate, and together with realizing high-quality processing, is able to deal with transporting a flexible substrate in an opposite direction.

## Description

### TECHNICAL FIELD

The present invention relates to a flexible substrate position control device, and more particularly, to a control device that controls the position of a band-shaped flexible substrate in the width direction in a processing device that carries out processing such as film deposition while transporting the flexible substrate.

### BACKGROUND ART

Although rigid substrates are normally used for the substrates of thin film laminates such as semiconductor thin films, there are also cases in which flexible substrates such as plastic films are used for the purpose of improving productivity and reducing costs by affording greater handling ease as a result of being lightweight and being able to be handled in rolls. For example, Patent Document 1 discloses a production device of a thin film laminate (thin film photoelectric conversion element) that laminates and forms a plurality of thin films of different properties on a flexible substrate and winds into a finished product roll using a plurality of deposition units arranged in the direction of transport of the flexible substrate while intermittently transporting a band-shaped flexible substrate (polyimide film) supplied from an unwinding roller at a prescribed pitch.

Patent Document 1: Japanese Patent Application Laid-Open No. 2005-72408

### DISCLOSURE OF THE INVENTION

There are two types of such thin film laminate production devices consisting of a type that carries out deposition while transporting in a horizontal orientation, namely while transporting with the direction of width of the band-shaped flexible substrate being the horizontal direction, and a type that carries out deposition while transporting in a vertical orientation, namely while transporting with the direction of width of the band-shaped flexible substrate being the vertical direction. Although the latter offers advantages such as having a small installation area and being more resistance to soiling of the substrate surface in comparison with the former, if the transport span becomes excessively long, it becomes difficult to maintain a constant transport height in opposition to gravity, thereby resulting in the occurrence of wrinkles in the surface of the flexible substrate or causing the tendency for the flexible substrate to sag to become prominent.

Patent Document 1 discloses a device that grips the upper and lower edges of a flexible substrate with a gripping member (pad) and pulls in the direction of width during a stop period of stepwise transport of the flexible substrate. However, since this device repeats gripping, pulling and release of the flexible substrate, it is difficult to maintain the flexible substrate at a constant transport height, and is also unable to realize a continuous deposition device that carries out deposition while continuously transporting flexible substrates.

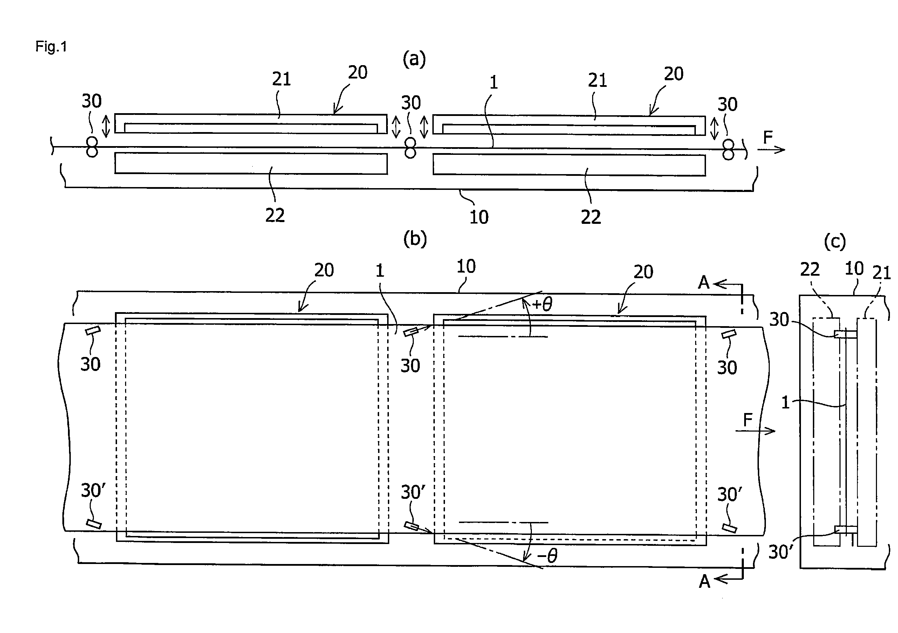

Therefore, as shown in FIGS. 1A to 1C, a device has been developed by the inventors of the present invention in which pairs of upper and lower clamping rollers 30 and 30' that clamp the upper and lower edges of a flexible substrate 1 are arranged between each of deposition units 20 that compose a thin film laminate production device, the rotating directions of each of the clamping rollers at clamping portions have deflection angles of +θ and -θ towards the upward diagonal direction and downward diagonal direction relative to a transport direction F of the flexible substrate 1, and the transport height of the flexible substrate 1 is adjusted by allowing a lifting force and a lowering force acting upward and downward to act on the upper and lower edges of the flexible substrate 1.

Although this device is advantageous in terms of deploying the flexible substrate and adjusting the transport height of the flexible substrate, it cannot be applied to a reciprocating deposition process that includes transport of flexible substrates in the opposite direction. If flexible substrates are transported in the opposite direction, the lifting force and lowering force attributable to the above-mentioned deflection angles act in opposite directions, thereby causing the problem of the clamping rollers 30 and 30'.

With the foregoing in view, an object of the present invention is to provide a flexible substrate position control device that is able to transport band-shaped flexible substrates in a vertical orientation while inhibiting the occurrence of sagging and wrinkling of flexible substrates, and together enabling high-quality processing, is able to accommodate transport of flexible substrates in the opposite direction.

In order to achieve the above-mentioned object, a first aspect of the present invention is a flexible substrate position control device in a processing device that transports a band-shaped flexible substrate in the horizontal direction and in a vertical orientation while carrying out processing of the substrate by processing units installed in a transport path of the substrate, the control device being provided with: a pair of clamping rollers that clamp an upper edge of the substrate; a support mechanism that rotatably supports the pair of clamping rollers while allowing these rollers to mutually contact and separate from each other; urging means for applying pressing force to the pair of clamping rollers through the support mechanism; and adjusting means for adjusting the pressing force applied by the urging means, wherein the pair of clamping rollers have an inclination in which the direction of pressing relative to a clamping surface of the substrate is towards the edge of the substrate in the direction of width, and are supported by the support mechanism such that the rotating direction at the clamping surface is the same direction as the transport direction of the substrate.

In addition, in order to achieve the above-mentioned object, a second aspect of the present invention is a flexible substrate position control device in a processing device that transports a band-shaped flexible substrate in the horizontal direction and in a vertical orientation while carrying out processing of the substrate by processing units installed in a transport path of the substrate, the control device being provided with: a support mechanism that rotatably supports the pair of clamping rollers while allowing these rollers to mutually contact and separate from each other; urging means for applying pressing force to the pair of clamping rollers through the support mechanism; and adjusting means for adjusting the pressing force applied by the urging means, wherein the pair of clamping rollers have an inclination, in which respective axial directions thereof move away relative to a clamping surface of the substrate towards an edge of the substrate in the width direction, and are supported by the support mechanism such that the rotating direction at the clamping surface is the same direction as the transport direction of the substrate.

In the above-mentioned processing device, the flexible substrate is transported in a vertical orientation, namely in the horizontal direction in which the direction of width is the vertical direction, by transport means such as unwinding rollers respectively arranged upstream and downstream from processing units (deposition units), and undergoes processing such as deposition with the processing units installed in the transport path of the substrate. At that time, the upper edge of the flexible substrate is clamped by the pair of clamping rollers that compose the position control device. In the first aspect, since the pair of clamping rollers have an inclination in which the direction of pressing relative to the clamping surface of the substrate is towards the edge of the substrate in the direction of width, the pressing force applied by the urging means has a vertical pressing component relative to the clamping surface of the substrate and a deploying component that acts towards the edge of the substrate along the clamping surface of the substrate. Thus, by adjusting the pressing force of the urging means and adjusting the deploying component (force component) acting towards the edge of the substrate together with the pressing component, the vertical position of the flexible substrate in the direction of width can be adjusted and the transport height can be maintained constant.

In addition, in the second aspect, since the pair of clamping rollers have an inclination in which their respective axial directions move away relative to the clamping surface of the substrate towards the edge of the substrate in the direction of width, deploying force towards the edge of the substrate relative to the clamping surface of the substrate is generated by driven rotation of the clamping rollers. Thus, by adjusting the pressing force of the urging means and adjusting the deploying force, the vertical position of the flexible substrate in the direction of width can be adjusted and the transport height can be maintained constant.

In this manner, in either of these aspects, the upper edge of the flexible substrate is deployed towards the edge, and sagging and wrinkling caused by its own weight at an intermediate portion of the transport span are inhibited. Moreover, since the above-mentioned control is not dependent on the rotating direction of each of the clamping rollers at the clamping surface, and the rotating directions at the clamping surface are the same as the transport direction of the substrate, similar position control can be carried out during transport in the opposite direction as well, thereby making it possible to inexpensively accommodate various types of reciprocating processes such as a reciprocating deposition process that includes transport of a flexible substrate in the opposite direction.

In a preferable aspect of the present invention, respective peripheral surfaces of the rollers that compose the pair of clamping rollers have an arc-shaped cross-section, and the rollers are supported by the support mechanism so as to be able to contact and separate from each other while being offset in the axial direction. In this aspect, since the inclination of the direction of pressing is imparted according to the cross-sectional shape of each of the clamping rollers, it is not necessary to incline the axial direction of each of the clamping rollers, and for example, the axial direction of each clamping roller in the clamped state can be set to a vertical direction parallel to the transport surface, which is advantageous in terms of simplifying the support mechanism. Moreover, the inclination angle of the direction of pressing can be easily set corresponding to the amount of offset in a state in which the axial direction of each clamping roller is maintained parallel, and the deploying component that acts towards the edge of the substrate can be changed over a wide range simply by changing the pressing force.

In a preferable aspect of the present invention, one or both of the rollers that compose the pair of clamping rollers is a tapered roller having a peripheral surface inclined in the axial direction thereof. In these aspects as well, since inclination of the direction of pressing is imparted according to the cross-sectional shape of each of the clamping rollers, this is advantageous in terms of simplifying the support mechanism, and the deploying component that acts towards the edge of the substrate can be changed over a wide range simply by changing the pressing force.

In each of the above-mentioned aspects, each of the pair of clamping rollers is preferably supported by the support mechanism so that the clamping surface has an inclination relative to the direction of width of the substrate. In this aspect, since the edge of the flexible substrate is clamped in a state in which it is bent towards the central portion of the substrate that includes a deposition region, a large clamping force can be obtained in comparison with contact pressure of the clamping rollers.

In a preferable aspect of the present invention, the support mechanism includes a first link that enables one or both of the pair of clamping rollers to move in a direction of mutual contact and separation, and a second link that enables the clamping rollers to move in the direction of width of the substrate, the urging means includes a first urging member that urges the first link in the direction in which the clamping rollers are pressed together, and a second urging member that urges the second link in a direction towards the edge of the substrate in the width direction, and the pressing force adjusting means includes urging force adjusting means of the second urging member.

In contrast to the previously described first aspect having a configuration that generates a pressing force and deploying force (force component) since the direction in which the clamping rollers are pressed (direction of contact and separation) by urging of the urging means (urging member) has an inclination relative to the clamping surface, in this aspect, by employing a configuration in which pressing force and deploying force are generated separately by two links corresponding to urging in two directions consisting of a direction of contact and separation roughly perpendicular to the clamping surface and a direction roughly parallel to the clamping surface, the vertical position of the flexible substrate in the direction of width can be adjusted and transport height can be maintained constant by changing deploying force corresponding to displacement of the second link or the second urging member and raising or lowering the edges of the flexible substrate in a state in which pressing force by the first link and the first urging member is kept roughly constant.

In a preferable aspect of the present invention, the support mechanism further includes a third link that enables a support point of the first link to move in the direction of width of the substrate. In this aspect, by displacing the support point of the first link with the third link, the flexible substrate can be deployed accompanying substantial movement of the clamping rollers over the clamping surface, and the transport height and degree of deployment of the substrate can be adjusted over an even wider range. In addition, by moving the third link in the opposite direction during pressing, there is the additional advantage of enabling an operation to be carried out that separates the clamping rollers and releases clamping.

In a preferable aspect of the present invention, the support mechanism includes a first link that enables one or both of the pair of clamping rollers to move in the direction in which these rollers mutually contact and separate from each other, a second link that pivotably supports one or both of the pair of clamping rollers in the direction of width of the substrate, and a return spring that urges one or both of the clamping rollers in a direction opposite to the edge of the substrate in the width direction through the second link, and the urging means includes a first urging member that urges the first link in the direction of contact and separation of the clamping rollers, while one or both of the clamping rollers is composed so as to be pressed at a pivot angle at which pressing force by the first urging member and restoring force by the return spring are in equilibrium.

In this aspect, by changing the pivot angle by adjusting the pressing force of the first urging member and displacing the clamping surface in the direction of width of the substrate, the vertical position of the flexible substrate can be adjusted. Namely, the vertical position in the direction of width can be adjusted while deploying the flexible substrate accompanying displacement of the clamping surface of the pair of clamping rollers in the direction of substrate width, and the transport height and degree of deployment of the substrate can be adjusted over an even wider range simply by adjusting the pressing force of the first urging means.

In the above-mentioned aspects in which the support mechanism includes a plurality of links and urging members, links and urging members may also be set respectively corresponding to each of the clamping rollers.

The present invention is also applicable to an aspect in which pairs of clamping rollers are arranged above and below a flexible substrate. Namely, in a preferable aspect of the present invention, a pair of lower clamping rollers that clamp a lower edge of the substrate, and a support mechanism and urging means, which are composed in the same manner as the above-mentioned support mechanism and urging means, for the pair of lower clamping rollers are further provided. In this aspect, by adjusting the pressing force, the flexible substrate can be raised or lowered and transport height can be controlled according to the difference between deploying components of pressing force that act on each of the upper and lower clamping surfaces while deploying the flexible substrate in both the upward and downward directions in the direction of width, thereby effectively inhibiting wrinkling of the flexible substrate and making it possible to further improve positional accuracy of the flexible substrate.

In a preferable aspect of the present invention, the processing device is a thin film laminate production device that is provided with a plurality of deposition units serving as processing units arranged in a row at an equal pitch along the transport path of the substrate and that sequentially laminates and forms thin films on the surface of the substrate successively while intermittently transporting the substrate at a pitch corresponding to the deposition units, wherein the pair of upper clamping rollers and the pair of lower clamping rollers are arranged between the plurality of deposition units.

In a preferable aspect of the present invention, the processing device is a thin film laminate production device that laminates and forms thin films on the surface of the substrate at deposition units serving as the processing units while continuously transporting the substrate, wherein a plurality of the pairs of upper clamping rollers and a plurality of the pairs of lower clamping rollers are arranged along the transport direction above and below the deposition units.

In the above-mentioned aspect, a plurality of support rollers arranged along the transport direction in which the substrate is supported are further preferably provided, respectively, between a thin film formation region of the substrate and the plurality of pairs of upper clamping rollers and the plurality of pairs of lower clamping rollers. In this aspect, together with the flexible substrate being able to be reliably supported in the vicinity of deposition units by heat-resistant support rollers not including a moving portion for adjusting pressing force, groups of pairs of clamping rollers can be arranged at a distance from the high-temperature deposition units, thereby making it possible to decrease the effects of radiant heat on the clamping rollers, which is advantageous in terms of improving degree of freedom when selecting the material of the clamping rollers.

The present invention can also be applied to a flexible substrate position control device in a processing device that carries out processing such as deposition by transporting a band-shaped flexible substrate in a horizontal, vertical or diagonal direction in an orientation other than a vertical orientation such as a horizontal orientation.

For example, a second aspect of the present embodiment as described above is a flexible substrate position control device in a processing device that carries out processing on the substrate by processing units installed in a transport path of the substrate while transporting a band-shaped flexible substrate, the control device being provided with: respective pairs of clamping rollers that clamp each edge of the substrate; respective support mechanisms that rotatably support each of the pairs of clamping rollers while respectively allowing each of the pairs to contact and separate from each other; urging means for applying pressing force to each of the pair of clamping rollers through each of the support mechanisms; and adjusting means for adjusting the pressing force applied by the urging means, wherein the flexible substrate position control device can be applied as a flexible substrate position control device, in which each of the pairs of clamping rollers has an inclination in which each of the axial directions thereof moves away toward an edge of the substrate in the width direction relative to a holding surface of the substrate, and are supported by each of the support mechanisms so that the rotating direction at the clamping surface is the same direction as the transport direction of the substrate.

In this aspect, deploying force towards each edge of the substrate relative to the clamping surface of each edge is generated by driven rotation of each of the pairs of clamping rollers that respectively clamp each edge of the flexible substrate, and the flexible substrate is deployed in the direction of with by this deploying force. Moreover, since this deploying force changes corresponding to the pressing force by each urging means, by respectively adjusting the pressing force by the urging means on each side, the position of the flexible substrate in the direction of width can be adjusted, and snaking of the flexible substrate can be inhibited while deploying in the direction of width. Since these actions are not dependent on the rotating direction of each clamping roller, and the rotating direction at each clamping surface is the same direction as the transport direction of the substrate, position control can be similarly carried out for transport in the opposite direction as well.

In this aspect as well, each roller that composes each of the pairs of clamping rollers is preferably a tapered roller having a peripheral surface inclined relative to the axial direction thereof.

As has been previously described, the flexible substrate position control device according to the present invention is able to effectively inhibit the occurrence of sagging and wrinkling of a flexible substrate when carrying out processing such as deposition while transporting a band-shaped flexible substrate, and together with realizing high-quality processing by maintaining a constant position in the direction of width, reciprocating processes that include transport of a flexible substrate in opposite directions can also be accommodated inexpensively.

### BRIEF DESCRIPTION OF THE DRAWINGS

FIG. 1A is a schematic overhead view showing a portion of a thin film laminate production device, FIG. 1B is a schematic side view thereof, and FIG. 1C is a cross-sectional view taken along line A-A in FIG. 1B;
FIG. 2 is a front view showing a substrate position control device according to a first embodiment of the present invention;
FIG. 3 is an enlarged view of an essential portion of FIG. 2;
FIG. 4A is a schematic overhead view showing one deposition unit of a stepwise deposition device that applies a substrate position control device according to a first embodiment of the present invention, and FIG. 4B is a schematic side view thereof;
FIG. 5 is a cross-sectional view taken along line B-B of FIG. 4B;
FIG. 6A is a schematic overhead view showing one deposition unit of a continuous deposition device that applies a substrate position control device according to a first embodiment of the present invention, and FIG. 6B is a schematic side view thereof;
FIG. 7 is a cross-sectional view taken along line C-C of FIG. 6B;
FIG. 8 is a front view showing a substrate position control device according to a second embodiment of the present invention;
FIG. 9 is an enlarged view of an essential portion of FIG. 8;
FIG. 10 is a cross-sectional view as viewed from the upstream side in the direction of transport showing a variation in the case of applying a substrate position control device according to a second embodiment of the present invention to a continuous deposition device;
FIG. 11 is a cross-sectional view as viewed from the upstream side in the direction of transport showing another variation in the case of applying a substrate position control device according to a second embodiment of the present invention to a continuous deposition device;
FIG. 12 is a front view showing a substrate position control device according to a third embodiment of the present invention;
FIG. 13 is an enlarged view of an essential portion of FIG. 12;
FIG. 14 is a front view showing a substrate position control device according to a fourth embodiment of the present invention;
FIG. 15 is an enlarged view of an essential portion of FIG. 14;
FIG. 16A is a front view showing a substrate position control device according to a fifth embodiment of the present invention in a released state, FIG. 16B shows a state in which pressing force is applied, and FIG. 16C shows a state in which deploying force is applied;
FIG. 17A is a front view showing a substrate position control device according to a sixth embodiment of the present invention in a released state, FIG. 17B shows a state in which pressing force is applied, and FIG. 17C shows a state in which deploying force is applied;
FIG. 18A is a front view showing a substrate position control device according to a seventh embodiment of the present invention in a released state, FIG. 18B is an enlarged view of an essential portion thereof, and FIG. 18C shows a state in which deploying force is applied;
FIG. 19A is a front view showing a substrate position control device according to an eighth embodiment of the present invention in a released state, FIG. 19B is an enlarged view of an essential portion in a state in which pressing has begun, and FIG. 19C shows a state in which deploying force is applied;
FIG. 20 is a front view showing a substrate position control device according to a ninth embodiment of the present invention;
FIG. 21A is an enlarged view of an essential portion of a pair of clamping rollers according to a ninth embodiment of the present invention in which inclination angles in the axial direction differ, and FIG. 21B is a schematic side view showing deploying action being applied in both the forward and reverse directions thereof;
FIG. 22A is a schematic overhead view showing a portion of a stepwise deposition device that applies a substrate position control device according to a ninth embodiment of the present invention, FIG. 22B is a schematic side view thereof, and FIG. 22C is a cross-sectional view taken along D-D of FIG. 22B;
FIG. 23 is a cross-sectional view showing a continuous deposition device that applies a substrate position control device according to a ninth embodiment of the present invention;
FIG. 24 is a cross-sectional view showing a continuous deposition device that applies a substrate position control device according to a ninth embodiment of the present invention in a different form; and
FIG. 25 is a cross-sectional view showing another continuous deposition device that applies a substrate position control device according to a ninth embodiment of the present invention.

### BEST MODE FOR CARRYING OUT THE INVENTION

The following provides a detailed explanation with reference to the appended drawings of embodiments of the present invention while using as an example the case of applying the present invention to a substrate position control device of a thin film laminate production device that composes a thin film photoelectric conversion element for a solar cell. Furthermore, in the following explanation, common or corresponding reference symbols are used to indicate common or corresponding constituents of each embodiment, and explanations thereof may be omitted.

### (First Embodiment)

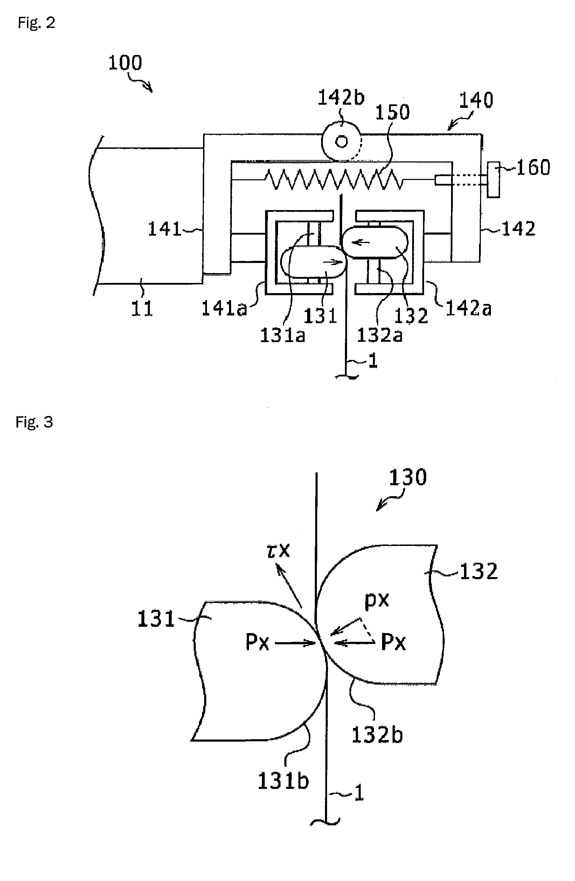

FIG. 2 is a front view as viewed from the upstream side in the direction of transport showing a substrate position control device 100 according to a first embodiment of the present invention. As partially shown in FIG. 1, a thin film laminate production device is provided with transport means within a vacuum chamber 10 maintained at a prescribed degree of vacuum that transports a band-shaped flexible substrate 1 (flexible film) in a horizontal direction with the direction of width thereof being the vertical direction, and laminates and forms a thin film on a surface of the flexible substrate 1 with a plurality of deposition units 20 arranged in a row along the transport path of the flexible substrate 1.

Rollers such as feed rollers and tension rollers that compose the transport means are arranged on the upstream side and downstream side of the deposition units in the direction of transport, and an unwinding roller and winding roller of the flexible substrate 1 are arranged on the upstream side and downstream side thereof in the direction of transport. In addition, guide rollers (idle rollers) that guide the flexible substrate 1 so as to turn around on the upstream sides and downstream sides of the deposition units, and set a linear transport path of the flexible substrate 1 at the deposition units are arranged between the upstream side and downstream side feed rollers and the deposition units. Since the configurations thereof are the same as those of the prior art, they are not shown in the drawings.

The substrate position control device 100 maintains a constant transport height by controlling the position in the vertical direction of the flexible substrate 1 suspended between the guide rollers and transported through the deposition units, is arranged above the transport path in the deposition units in order to deploy the flexible substrate 1 in the direction of width, namely the vertical direction, and is composed of, for example, a pair of clamping rollers 130 that clamp the upper edge of the flexible substrate 1, a support mechanism 140 that rotatably supports each of rollers 131 and 132 that compose the pair of the clamping rollers 130 while allowing these rollers to mutually contact and separate from each other, urging means (150) that applies pressing force to the pair of holding rollers 130 (131,132) through the support mechanism 140, and pressing force adjusting means (160).

In the substrate position control device 100 according to the first embodiment of the present invention, one of each of the rollers that compose the pair of clamping rollers 130 is a stationary roller 131 while the other is a movable roller 132, the stationary roller 131 is rotatably supported by a shaft 131a, and the movable roller 132 is rotatably supported by a shaft 132a. The shaft 131a of the stationary roller 131 is arranged in the vertical direction parallel to the transport surface of the flexible substrate 1, and the upper and lower ends are supported from the lower end of a stationary side support member 141 with a roughly U-shaped support 141a provided protruding in a direction perpendicular to the direction of transport. The stationary side support member 141 is fixed to a structural element 11 of a vacuum chamber.

On the other hand, the upper and lower ends of the shaft 132a of the movable roller 132 are supported from the distal end of a movable side support member 142 with a similarly shaped support 142a provided protruding in opposition to the support 141a, and in an operating state in which the pair of clamping rollers 130 are pressed together, the shaft 132a of the movable roller 132 is set so as to be parallel to the shaft 131a of the stationary roller 131. The movable side support member 142 extends upward from the distal end from which the support 142a protrudes, is further bent to extend towards the upper end of the stationary side support member 141, and at a hinge 142b positioned above the transport surface, is pivotably coupled to the upper end of the stationary side support member 141, and the movable roller 132 is able to contact and separate from the stationary roller 131 due to pivoting of the movable side support member 142 centering about the hinge 142b.

A spring 150 (tension spring) is interposed as urging means between the stationary side support member 141 and the movable side support member 142. One end of the spring 150 is connected to the stationary side support member 141, the other end of the spring 150 is connected to the movable side support member 142 through a pressing force adjustment screw 160, and by adjusting initial displacement of the spring 150 by turning the pressing force adjustment screw 160, pressing force (contact pressure) of the movable roller 132 on the stationary roller 131 can be adjusted.

As shown in FIGS. 2 and 3, in each of the rollers 131 and 132 of the pair of clamping rollers 130 according to the first embodiment of the present invention, peripheral surfaces 131b and 132b that clamp the flexible substrate 1 have an arc-shaped cross-section, are mutually offset in the axial direction, and are supported by the shafts 131a and 132a, respectively. Although not shown in the drawings, each of the rollers 131 and 132 are formed with, for example, metal, ceramic or plastic, or are composed by adhering an elastic material such as rubber to the periphery of a core formed with these materials.

Each of the rollers 131 and 132 are rotatably supported through bearings able to bear thrust loading so as to be held at the locations offset in the axial direction by the shafts 131a and 132a (bearings), respectively. Alternatively, each of the rollers 131 and 132 may be adhered to the locations offset in the axial direction by the shafts 131a and 132a (rotating shafts), respectively, and each of the shafts 131a and 132a may be rotatably supported by the respective supports 141a and 142a through bearings able to bear thrust loading.

According to the configuration described above, as shown in FIG. 3, the upper edge of the flexible substrate 1 is clamped in a state of being bent diagonally relative to the vertical direction by the stationary roller 131 and the movable roller 132 offset in the axial direction. Consequently, a parallel deploying component τx (shear component) is generated relative to the clamping surface of the flexible substrate 1 with respect to a pressing component px input perpendicular to the clamping surface of the flexible substrate 1 by a pressing component Px of the movable roller 132 applied in roughly the horizontal direction so as to intersect the substrate transport surface, and the upper edge of the flexible substrate 1 is deployed upward by the deploying component τx towards the edge of this flexible substrate 1.

Since the pressing force Px applied by the movable roller 132 is proportional to elastic displacement of the spring 150, by turning the pressing force adjustment screw 160 and adjusting an initial displacement x of the spring 150, the deploying component τx is adjusted together with the pressing component px, the deploying force applied to the upper edge of the flexible substrate 1 can be adjusted, and since this deploying force (τx) becomes a lifting force that raises the upper edge of the flexible substrate 1 in opposite to its own weight, the position of the upper edge of the flexible substrate 1 can be adjusted.

Furthermore, although the case of operating after presetting the pressing force to an optimum value determined by test operation and the like using the pressing force adjustment screw 160 for manual operation as adjusting means of pressing force is shown in the example shown in the drawings, an actuator that turns the pressing force adjustment screw 160 that displaces the support point of the spring 150 either directly or indirectly through a mechanism, a sensor that detects the position of the upper edge of the flexible substrate 1, and a control device that controls the actuator based on a detected value of the sensor, can also be provided to employ a configuration capable of controlling transport height of the flexible substrate 1 by feedback control.

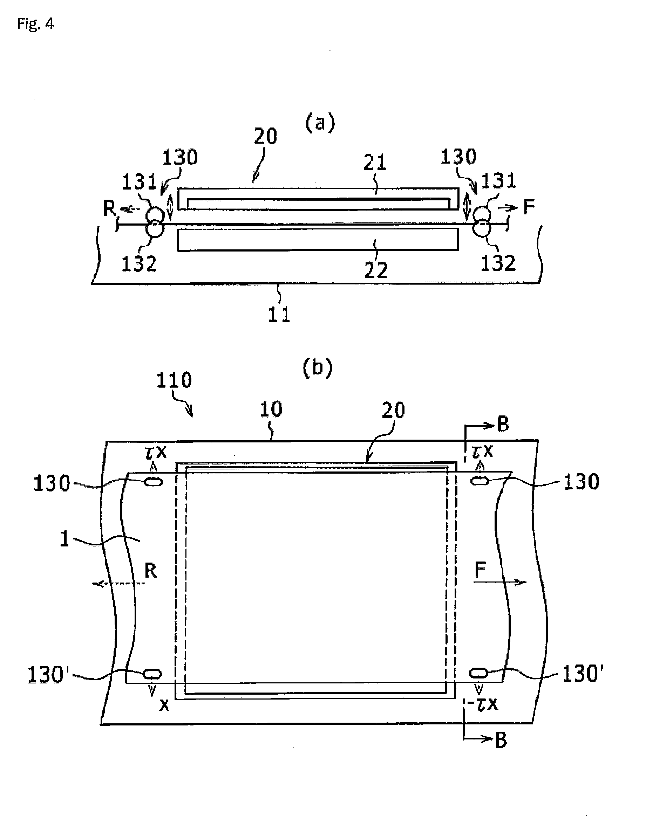

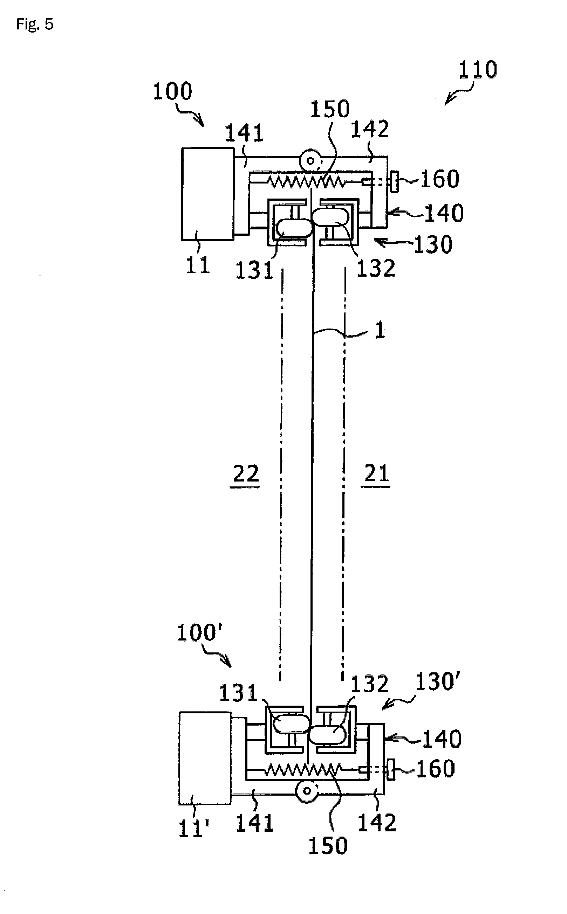

FIGS. 4A and 4B and FIG. 5 show an embodiment in which the substrate position control device 100 of the first embodiment is applied to a stepwise deposition type of production device 110 similar to that shown in FIG. 1. Although FIG. 4 only shows one deposition unit 20, as was previously described, a large number of the deposition units 20 are arranged in a row within the common vacuum chamber 10 along the direction of transport. Each of the deposition units 20 is composed of a vacuum deposition unit for carrying out chemical vapor deposition (CVD) such as plasma CVD or physical vapor deposition (PVD) such as sputtering.

Each of the deposition units 20 is composed of an electrode 21 (high-frequency electrode or target having a large number of raw material gas discharge holes in the surface thereof) and a ground electrode 22 containing an internal heater arranged in opposition on both sides of the flexible substrate 1 with the flexible substrate 1 interposed there between, and the electrode 21 and the ground electrode 22 are respectively housed in a chamber that opens towards the transport surface of the flexible substrate 1. In this stepwise deposition process, since the electrode 21 and/or the ground electrode 22 advance and withdraw so as to open and close the chamber during stoppage of stepwise transport corresponding to a single deposition unit 20, the pair of clamping rollers 130 cannot be installed between the electrode 21 and the ground electrode 22.

Therefore, in the stepwise deposition type of production device 110, the substrate position control device 100 is installed before and after the deposition unit 20 in avoidance thereof, namely is installed between each of the deposition units 20. In the example shown in the drawings, pairs of clamping rollers 130 and 130' are respectively arranged on each of the upper and lower sides of the transport path. The lower pair of clamping rollers 130' can use a similar structure to that of the upper pair of clamping rollers 130 by inverting vertically.

In this aspect, the deploying force τx that is applied upward to the upper edge of the flexible substrate 1 by the upper pair of clamping rollers 130 is allowed to act simultaneous to the deploying force τx that is applied downward to the lower edge of the flexible substrate 1 by the lower pair of clamping rollers 130' , and together with being able to deploy the flexible substrate 1 in both the upward and downward directions, the difference there between becomes a force that lifts the flexible substrate 1 in opposition to its own weight. Thus, in the case each of the upper and lower pairs of clamping rollers 130 and 130' have a large effect due to the weight thereof such as in the case of a long transport span, the deploying force of the upper pair of clamping rollers 130 is set to a range that is larger than that of the lower pair of clamping rollers 130'.

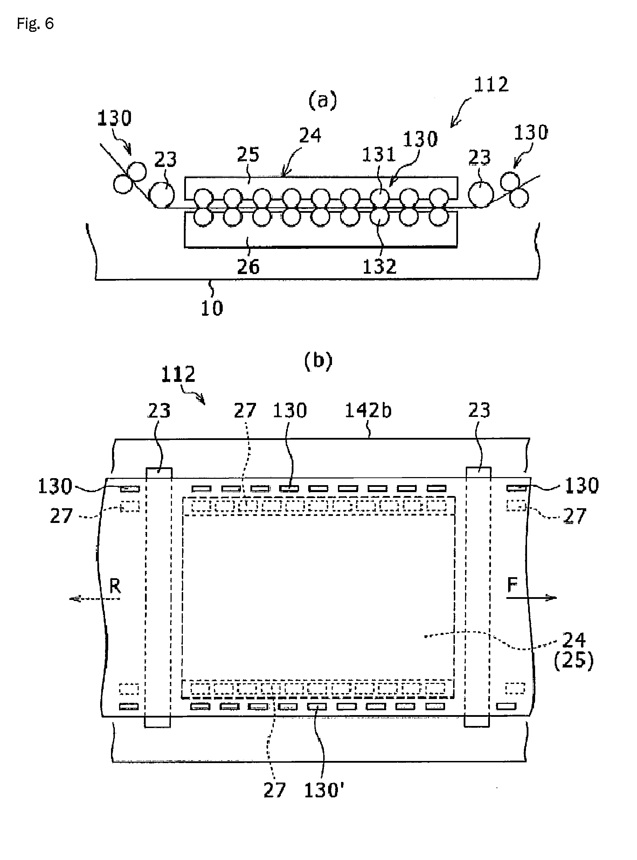

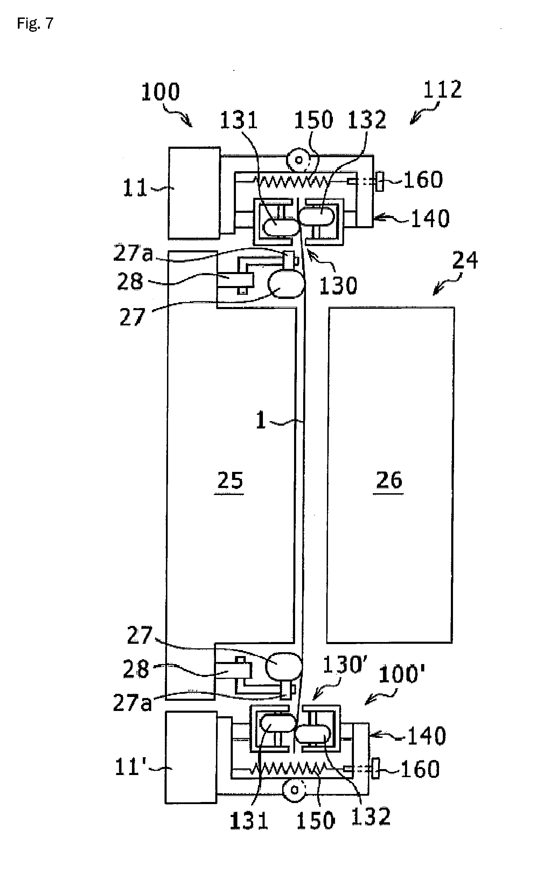

FIGS. 6A and 6B and FIG. 7 show an embodiment in which the substrate position control device 100 of the first embodiment is applied to a continuous deposition type of production device 112. Each of deposition units 24 of the continuous deposition type of production device 112 have an electrode (target) 25 and a ground electrode 26 containing an internal heater arranged in opposition on both sides of the flexible substrate 1 with the flexible substrate 1 interposed there between. However, the electrode 25 and the ground electrode 26 are fixed at a prescribed gap relative to the flexible substrate 1, and continuous deposition is carried out in a non-contact manner. Consequently, a deposition region on the flexible substrate 1 is not partitioned in the direction of transport, and rollers 23 that guide the flexible substrate 1 can be arranged on the upstream and downstream sides of the deposition units 24 in the direction of transport.

Thus, in the continuous deposition type of production device 112, emphasis is placed on deploying the flexible substrate 1 in the direction of width in order to inhibit wrinkling from occurring in the flexible substrate 1 due to tension and heat rather than on sagging of the flexible substrate 1 due to its own weight, and as shown in the drawings, a plurality of the upper and lower pairs of clamping rollers 130 and 130' are respectively linearly arranged along the both the upper and lower sides of the deposition units 24. However, in the continuous deposition type of production device 112, the periphery of the electrode 25 rises in temperature to about 300°C due to radiant heat from the heater. Therefore, in consideration of the effect of radiant heat on the pairs of clamping rollers 130 and 130', a plurality of support rollers 27 provided in a row along the direction of transport are arranged between the electrode 25 and each of the pairs of clamping rollers 130 and 130', and each of the pairs of clamping rollers 130 and 130' is arranged to outside the electrode 25.

The support rollers 27 are preferably composed of metal rollers having satisfactory heat resistance, and are rotatably supported by shafts 27a provided on the distal end of a bracket 28 provided protruding from the frame of the electrode 25. In addition, as shown in FIG. 7, each of the upper and lower pairs of clamping rollers 130 and 130' are arranged farther from the transport surface than the support rollers 27, and the flexible substrate 1 is stably supported by the support rollers 27.

### (Second Embodiment)

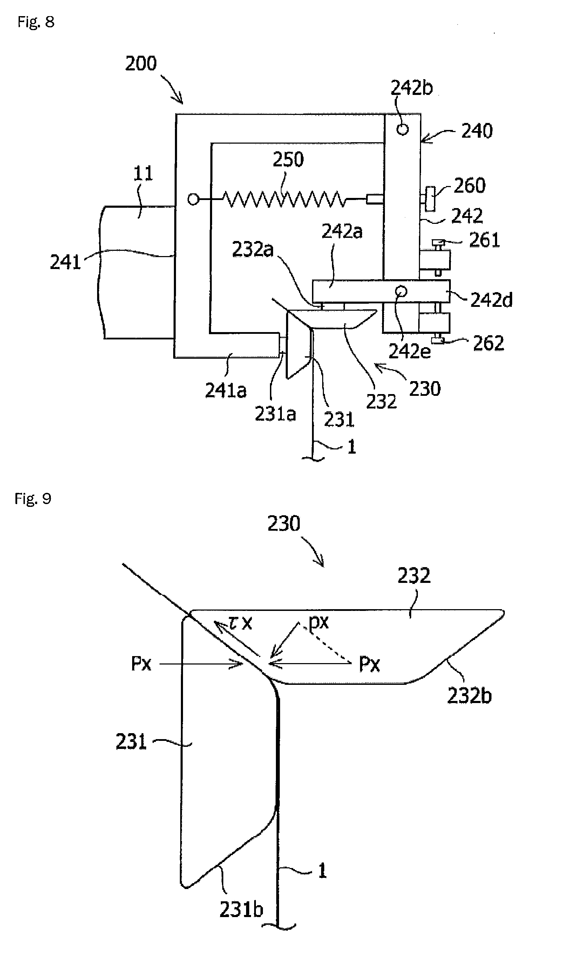

Next, FIG. 8 is a front view as viewed from the upstream side in the direction of transport showing a substrate position control device 200 according to a second embodiment of the present invention, and FIG. 9 is an enlarged view of an essential portion thereof. As shown in the drawings, each of rollers 231 and 232 that compose a pair of clamping rollers 230 of the substrate position control device 200 of the second embodiment are tapered rollers having peripheral surfaces 231b and 232b respectively inclined relative to the axial direction, and in an operation state in which the pair of clamping rollers 230 are mutually contacted and separated, in contrast to a movable roller 232 being set so that a shaft 232a thereof is parallel to the transport surface, by setting a shaft 231a of a stationary roller 231 in a direction perpendicular to the shaft 232a of the movable roller 232, each of the peripheral surfaces 231b and 232b inclined relative to the axial direction are mutually pressed together while forming a clamping surface inclined relative to the vertical direction, thereby being able to transport the flexible substrate 1 while clamping the flexible substrate 1.

In addition, a support 242a that supports the shaft 232a of the movable roller 232 is rotatably supported by a movable side supporting member 242 through a hinge 242e, and by adjusting adjustment screws 261 and 262 provided while able to make contact from both the upper and lower sides on the other end 242d of the support 242a, the position of the movable roller 232 can be adjusted relative to the stationary roller 231.

Each of the clamping rollers 231 and 232 are respectively rotatably supported by the shafts 231a and 232a (bearings) through bearings able to bear thrust loading, or are respectively fixed in the axial direction to the shafts 231a and 232a (rotating shafts), and each of the shafts 231a and 232a are respectively rotatably supported by supports 241a and 242a through bearings able to bear thrust loading, while other constituents are the same as those of the first embodiment.

According to the configuration described above, as shown in FIG. 9, the upper edge of the flexible substrate 1 is clamped by the stationary roller 231 and the movable roller 232 in a state in which it is bent diagonally relative to the vertical direction, the deploying component τx (shear component) along the clamping surface of the flexible substrate 1 is generated relative to the pressing component px input perpendicular to the clamping surface of the flexible substrate 1 by the pressing component Px of the movable roller 232 applied in roughly the horizontal direction, the upper edge of the flexible substrate 1 is deployed upward by the deploying component τx towards the edge of the flexible substrate 1, and in the same manner as the previously described first embodiment, the deploying component τx is adjusted together with the pressing component px and the position of the upper edge of the flexible substrate 1 can be adjusted by adjusting the initial displacement x of a spring 250.

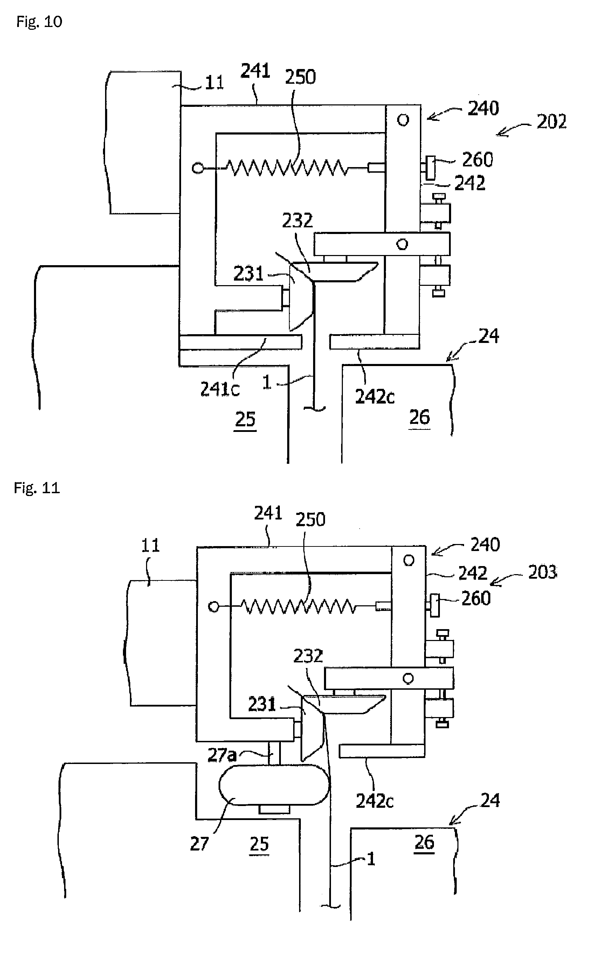

The substrate position control device 200 of the second embodiment can also be applied to a stepwise deposition type of production device and a continuous deposition type of production device in the same manner as the first embodiment, and FIGS. 10 and 11 show a variation of the case of applying the substrate position control device 200 to a continuous deposition type of production device.

In a variation 202 shown in FIG. 10, by providing radiant heat protective covers 241c and 242c on stationary side and movable side support members 241 and 242 of each of the clamping rollers 231 and 232 adjacent to the electrode 25 and the ground electrode 26 (heater), the support rollers (27) can be omitted and the structure can be simplified. The radiant heat protective covers 241c and 242c are preferably composed of materials that are heat-resistant and heat-insulating, are extended to the upstream side and downstream side in the direction of transport relative to the diameter of each of the clamping rollers 231 and 232, and the radiant heat protective covers 241c and 242c of adjacent clamping rollers 231 and 232 are preferably arranged in mutual proximity. This variation can also be applied to the previously described first embodiment as well as other embodiments to be subsequently described.

In addition, in a variation 203 shown in FIG. 11, by rotatably attaching the support roller 27 to a support shaft 27a provided protruding downward from the support 241a of the stationary side support member 241, the bracket (28) of the support roller 27 can be omitted, while on the other hand, by providing the radiant heat protective cover 242c on the movable side support member 242, the structure can be simplified. This variation can also be applied to the substrate position control device 100 of the previously described first embodiment as well as each of the embodiments that include a stationary roller in the pair of clamping rollers.

### (Third Embodiment)

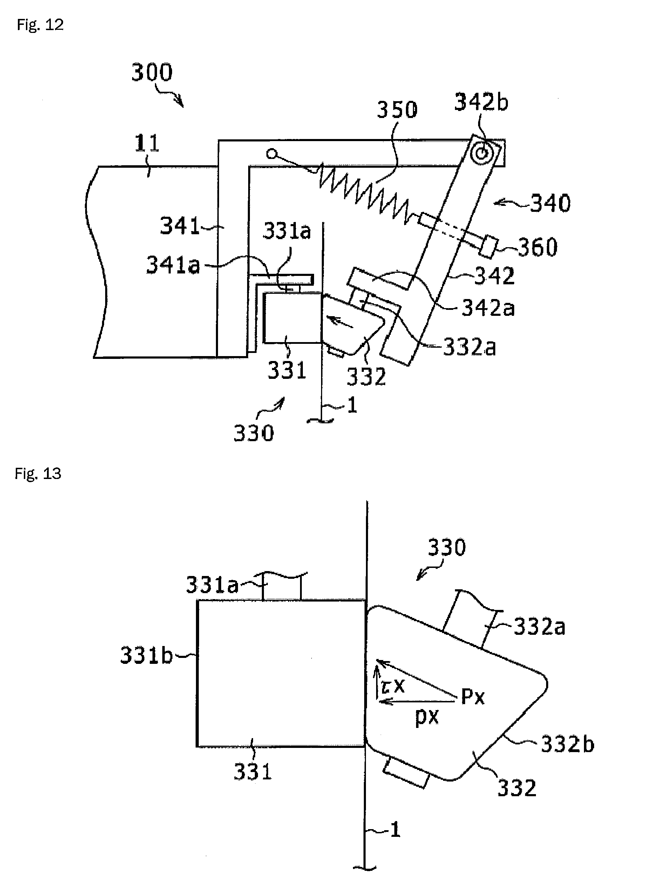

Next, FIG. 12 is a front view as viewed from the upstream side in the direction of transport showing a substrate position control device 300 according to a third embodiment of the present invention, and FIG. 13 is an enlarged view of an essential portion thereof. Each of rollers 331 and 332 that compose a pair of clamping rollers 330 of the substrate position control device 300 of the third embodiment have mutually different shapes. The stationary roller 331 is a cylindrical roller having a peripheral surface 331b parallel to the axial direction, and a shaft 332a is set in the vertical direction.

1 In contrast thereto, the movable roller 332 is a tapered roller having a peripheral surface 332b inclined relative to the axial direction, and in an operating state, the shaft 332a is set to have an inclination corresponding to the peripheral surface 332b so that the inclined peripheral surface 332b is pressed against the stationary roller 331 along a parallel peripheral surface 331b thereof. Moreover, a movable side support member 342, which rotatably supports the movable roller 332, is pivotably coupled through a hinge 342b at an extending portion extending to the side of the movable controller 332 from the upper end of a stationary side support member 341, and the movable roller 332 is able to contact and separate from the stationary roller 331 by pivoting of the movable side support member 342 centering about the hinge 342b.

A spring 350 is interposed as urging means between the stationary side support member 341 and the movable side support member 342, and the end of the spring 350 is connected to the movable side support member 342 through a pressing force adjustment screw 360. Although these points are the same as in the first and second embodiments, in the present embodiment, the spring 350 is suspended diagonally along the direction of pivoting of the movable side support member 342, and the pressing force adjustment screw 360 is also threaded diagonally.

According to the configuration described above, although the upper edge of the flexible substrate 1 is clamped in a flat state by the stationary roller 331 and the movable roller 332, the pressing component px input perpendicular to the clamping surface of the flexible substrate 1, namely horizontally, and the deploying component τx (shear component) parallel to the clamping surface of the flexible substrate 1, are generated by the pressing force Px of the movable roller 332 acting upward diagonally centering about the hinge 342b offset from the transport surface of the flexible substrate 1, the upper edge of the flexible substrate 1 is deployed upward by this deploying component τx, and similar to each of the previously described embodiments, the pressing component px and the deploying component τx are adjusted and the position of the upper edge of the flexible substrate 1 can be adjusted by adjusting the initial displacement x of the spring 350.

### (Fourth Embodiment)

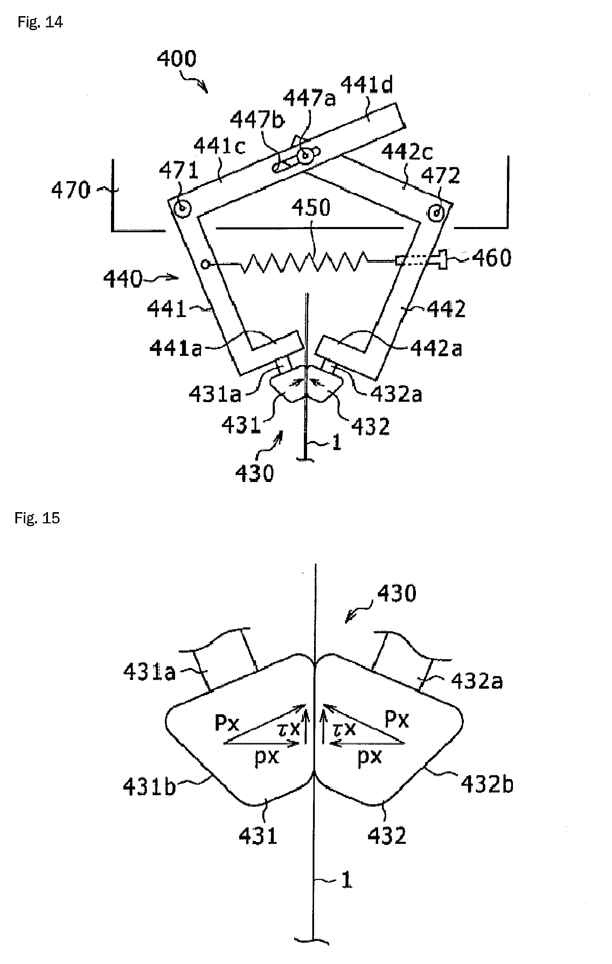

Next, FIG. 14 is a front view as viewed from the upstream side in the direction of transport showing a substrate position control device 400 according to a fourth embodiment of the present invention, and FIG. 15 is an enlarged view of an essential portion thereof. Each of rollers 431 and 432 that compose a pair of clamping rollers 430 of the substrate position control device 400 of the fourth embodiment are both composed in the form of tapered rollers, both of the rollers are movable rollers 431 and 432, and each is respectively rotatably supported by shafts 431a and 432a provided on distal portions 441a and 442a of movable side support members 441 and 442. In an operating state in which each of the movable rollers 431 and 432 are mutually pressed together, the shafts 431a and 432a of each of the movable rollers 431 and 432 are oriented diagonally corresponding to the inclination of peripheral surfaces 431b and 432b relative to the clamping surface so that the upper edge of the flexible substrate 1 is clamped at a flat clamping surface relative to the transport surface.

The movable side support members 441 and 442 are pivotably supported by shafts 471 and 472 fixed to a mounting bracket 470 at intermediate portions bent into an L-shape, and a spring 450 is interposed as urging means. One end of the spring 450 is connected to the movable side support member 442 through a pressing force adjustment screw 460 in the same manner as each of the previously described embodiments.

Moreover, a pin 447a and a slot 447b, which mutually engage while able to slide and rotate, are provided at the intersection of arms 441c and 442c extending above the transport surface from respective intermediate portions (shafts 471 and 472) thereof, and by pressing an operating portion 441d of one of the movable side support members 441 downward in opposition to urging force of the spring 450, the movable rollers 431 and 432 can be mutually moved apart, and if this pressing is released, the pair of movable side support members 441 and 442 mutually move in coordination due to the above-mentioned engagement of the pin 447a and the slot 447b, and the pair of movable rollers 431 and 432 are mutually pressed together by urging force of the spring 450, thereby enabling them to clamp the upper edge of the flexible substrate 1.

In the substrate position control device 400 of the fourth embodiment composed in the manner described above, although the upper edge of the flexible substrate 1 is clamped by the pair of movable rollers 431 and 432 in a flat state, the pressing components px input perpendicular to the clamping surface of the flexible substrate 1, namely roughly horizontally, and the deploying components τx parallel to the clamping surface of the flexible substrate 1, are generated by the pressing force Px mutually acting diagonally upward centering about the shafts 471 and 472 both offset from the transport surface of the flexible substrate 1, the upper edge of the flexible substrate 1 is deployed upward by the deploying components τx, and in the same manner as the each of the previously described embodiments, the pressing components px and the deploying components τx are adjusted and the position of the upper edge of the flexible substrate 1 can be adjusted by adjusting the initial displacement x of the spring 450.

In the previously described substrate position control devices of the first to fourth embodiments, each employed a configuration in which the pressing component px perpendicular to the clamping surface and a deploying component τx, namely a force component, parallel to the clamping surface, are generated as a result of the direction of pressing (direction of contact and separation) of a pair of clamping rollers by a single urging means (spring) having an inclination towards an edge of the flexible substrate 1 relative to the clamping surface. In contrast, in substrate position control devices of fifth to eighth embodiments to be subsequently described, as a result of employing a configuration in which a support mechanism is provided with two links and two urging members corresponding to urging in two directions consisting of a direction of contact and separation of a pair of rollers 530 roughly perpendicular to the clamping surface and a deploying direction roughly parallel to the clamping surface, pressing force px and deploying force τx are generated separately, thereby resulting in the characteristic of being able to adjust separately. The resultant force of the pressing force px and the deploying force τx can also be considered to be equivalent to Px that acts in direction diagonal to the clamping surface. The following provides a detailed explanation of the fifth to eighth embodiments of the present invention with reference to the drawings.

### (Fifth Embodiment)

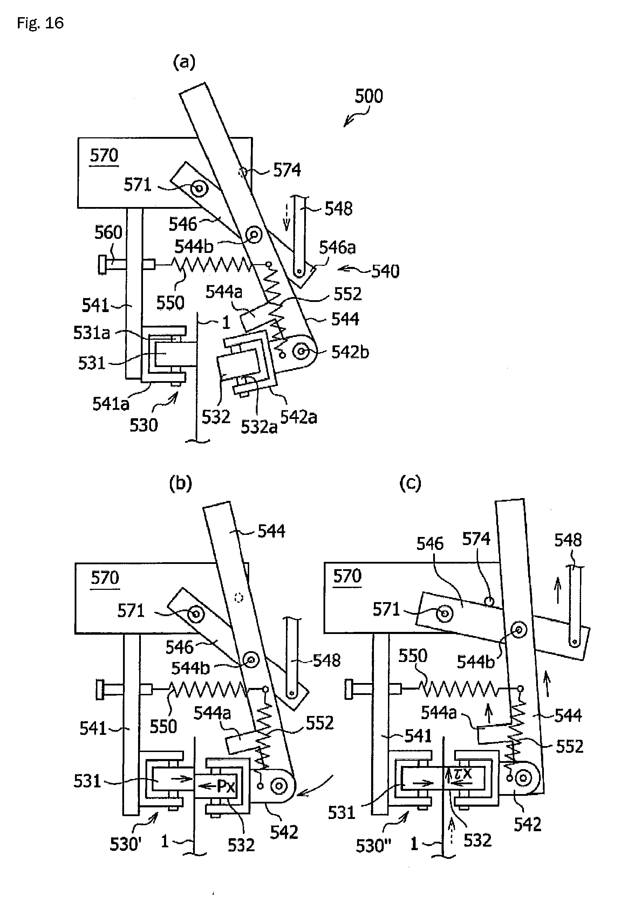

FIG. 16A is a front view as viewed from the upstream side in the direction of transport showing a substrate position control device 500 according to a fifth embodiment of the present invention in a state in which a pair of clamping rollers 530 are released, FIG. 16B shows a state in which pressing force is applied by the pair of clamping rollers 530, and FIG. 16C shows a state in which deploying force is applied. Although a stationary roller 531 and a movable roller 532 that compose the pair of clamping roller 530 of the substrate position control device 500 of the fifth embodiment are both shown as cylindrical rollers, either or both can also be rollers having an arc-shaped cross-section or tapered rollers. The stationary roller 531 is similar to that of the third embodiment.

The movable roller 532 is rotatably and unmovably supported in the axial direction by a support 542a on the distal end of a second link 542 through a shaft 532a. The second link 542 is pivotably supported by the distal end of a first link 544 at a hinge 542b on the proximal end thereof, is urged upward in the drawing, which is the direction of deployment, namely towards the side of an edge in the direction of width of the flexible substrate 1, by a second spring 552 (deploying spring) interposed between the second link 542 and the first link 544, and in the state in which the pair of clamping rollers 530 are released as shown in FIG. 16A, contacts a stopper 544a provided on the first link 544.

The first link 544 is pivotably supported by the distal end of a third link 546 at a hinge 544b located at an intermediate location in the lengthwise direction thereof, and is urged in a direction in which it approaches a stationary side support member 541 by a first spring 550 interposed through a pressing force adjustment screw 560 between a side distal to the hinge 544b (connecting point of the second spring 552 in the example shown in the drawings) and the stationary side support member 541. The third link 546 is pivotably supported with a shaft 571 fixed to a mounting bracket 570 at the proximal end thereof, and an operating member 548 that is raised and operated by driving means not shown is connected to an operating portion 546a on the other end thereof.

According to the configuration described above, in the substrate position control device 500 of the fifth embodiment, in the state in which the pair of clamping rollers 530 are released shown in FIG. 16A, the operating member 548 lowers and the third link 546 pivots downward in the drawing centering about the shaft 571, and while in this state, by pushing 544d an operating portion 544c extending on the opposite end of the first link 544 in opposition to urging force of the first spring 550, the first link 544 rotates in the counter-clockwise direction in the drawings centering about the hinge 544b, the movable roller 532 moves away from the stationary roller 531, and the flexible substrate 1 is able to be introduced there between.

When pushing 544d of the operating portion 544c is released from this state, the first link 544 first rotates in the clockwise direction in the drawings centering about the hinge 544b, and as shown in FIG. 16B, the movable roller 532 is pressed against the stationary roller 531 by a prescribed pressing force applied by the first spring 550, and the flexible substrate 1 is clamped there between. However, as a result of the third link 546 still being at the lowered position and upward pivoting of the second link 542 being restricted by the stopper 544a, the movable roller 532 is displaced downward and pressed against the stationary roller 531.

Next, as shown in FIG. 16C, when the operating portion 546a of the third link 564 is raised by the operating member 548 from this state, the third link 546 moves farther upward than the hinge 544b of the first link 544 due to rotation in the upward direction in the drawings of the third link 546, and the first link 544 is pulled up. Accompanying this, the second link 642 is released from the stopper 544a, the movable roller 532 is urged upward in the drawings by urging force (deploying force) of the second spring 552, the deploying force τx acts on the clamping surface of the flexible substrate 1, and the upper edge of the flexible substrate 1 is deployed upward by the deploying force τx.

In the substrate position control device 500 of the fifth embodiment, although the pressing force Px of the pair of clamping rollers 530 can be adjusted by adjusting the initial displacement x of the first spring 550 with the pressing force adjustment screw 560, since the pressing force Px acts perpendicular to the clamping surface, the pressing force Px per se does not have an inclined component. However, friction force at the clamping surface changes as a result of adjusting the pressing force Px, and this is reflected in the deploying force τx. In addition, although the operating member 548 contacts a pin 574 that limits rising of the operating member 548 in the example shown in the drawings, the deploying force τx can also be adjusted or controlled by adjusting or controllably composing the location in the vertical direction of the operating member 548 within the range of the pin 574. Alternatively, the deploying force τx can also be adjusted by providing a pressing force adjustment screw on one end of the second spring 552 in the same manner as the first spring 550, and adjusting the initial displacement x of the second spring 552.

### (Sixth Embodiment)

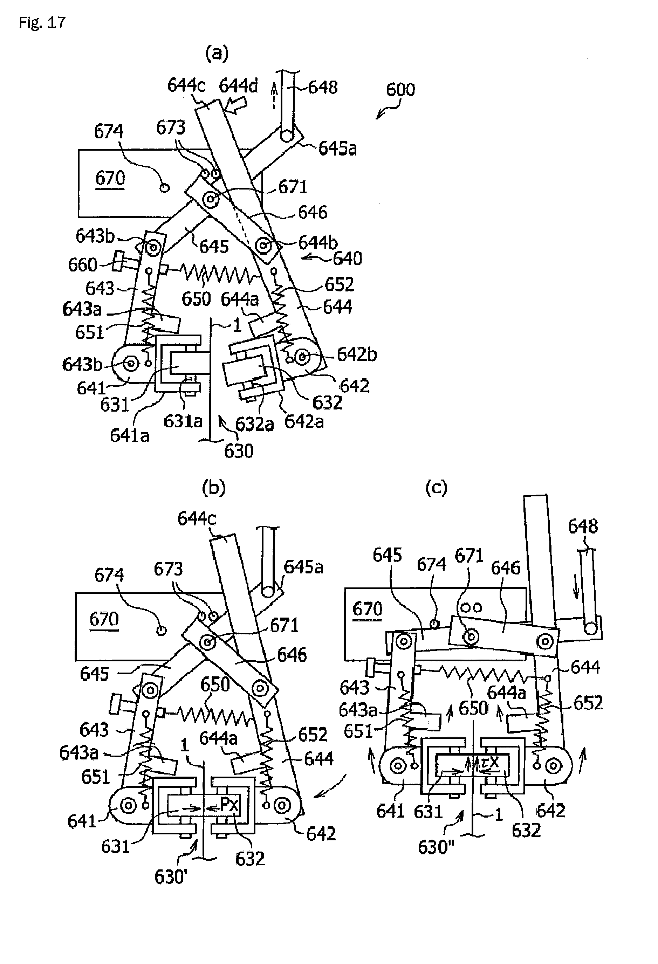

Next, FIG. 17A is a front view as viewed from the upstream side in the direction of transport showing a substrate position control device 600 according to a sixth embodiment of the present invention in a state in which a pair of clamping rollers 630 are released, FIG. 17B shows a state in which pressing force is applied by the pair of clamping rollers 630, and FIG. 17C shows a state in which deploying force is applied. Although the substrate position control device 600 of the sixth embodiment is similar to the fifth embodiment with respect to the basic operation thereof, each of the rollers 631 and 632 that compose the pair of clamping rollers 630 are both movable rollers, and are pivotably composed in a direction in which they mutually contact and separate from each other and in the vertical direction with respect to deploying action.

The movable rollers 631 and 632 are respectively rotatably and unmovably supported in the axial direction by each support 641a and 642a of second links 641 and 642 through shafts 631a and 632a. The second links 641 and 642 are respectively pivotably supported on the distal ends of first links 643 and 644 at hinges 641b and 642b on the proximal ends thereof, are urged upward in the drawing, which is the direction of deployment, namely towards the side of an edge in the direction of width of the flexible substrate 1, by second springs 651 and 652 (deploying springs) respectively interposed between the second links 641 and 642 and the first link 644, and in the state the pair of clamping rollers 630 are released as shown in FIG. 17A, contact stoppers 643a and 644a provided on the first links 643 and 644, respectively.

The first links 643 and 644 are respectively pivotably supported by the distal ends of third links 645 and 646 at hinges 643b and 644b located at an intermediate location in the lengthwise direction thereof, a first spring 650 (pressure spring) is interposed there between through a pressing force adjustment screw 660 at a side distal to the hinges 643b and 644b, and the first links 643 and 644 are urged in directions in which they mutually approach by the first spring 650. In addition, one of the first links 644 has an operating portion 644c further extending from the hinge 644b.

The third links 645 and 646 are pivotably supported with a common shaft 671 fixed to a mounting bracket 670 at respective proximal ends thereof, and the respective pivoting ranges thereof are restricted by pins 673 and 674. One of the third links 645 has an operating portion 645a further extending from the proximal end, and an operating member 648 that is raised and operated by driving means not shown is connected to the operating portion 645a.

According to the configuration described above, in the substrate position control device 600 of the sixth embodiment, in the state in which the pair of clamping rollers 630 are released shown in FIG. 17A, the operating member 648 rises and each of the third links 645 and 646 both pivot downward in the drawing to a lowered position at which their respective other ends contact the pins 673. While in this state, by pushing 644d the operating portion 644c of the first link 644 to the left in the drawings in opposition to urging force of the first spring 650, the movable roller 632 moves away from the other movable roller 631, and the flexible substrate 1 is able to be introduced there between.

When pushing 644d of the operating portion 644c is released from this state, the first link 644 rotates in the clockwise direction in the drawings centering about the hinge 644b, and as shown in FIG. 17B, the movable roller 632 is pressed against the other movable roller 631 by a prescribed pressing force applied by the first spring 650, and the flexible substrate 1 is clamped there between. Although the positions of the pair of clamping rollers were shifted vertically in the previously described fifth embodiment, in this sixth embodiment, since each of the links of the support mechanism 640 of the pair of clamping rollers 631 and 632 are laid out symmetrically with respect to the transport surface, there is no shifting in position, and the clamping rollers 631 and 632 clamp the flexible substrate 1 while at positions at the same height (lowered positions).

Next, when the operating portion 646a of one of the third links 645 is lowered by the operating member 648, as shown in FIG. 17C, the hinges 643b and 644b on the distal ends of each of the third links 645 and 646 both pivot upward in the drawings and each of the first links 643 and 644 are pulled upward. Accompanying this, each of the second links 641 and 642 are released from their corresponding stoppers 643a and 644a, and as a result of urging force of the second springs 651 and 652 being applied to each of the second springs 641 and 642, each of the movable rollers 631 and 632 are both urged upward in the drawings, the deploying force τx acts on the clamping surface of the flexible substrate 1, and the upper edge of the flexible substrate 1 is deployed upward.

In the substrate position control device 600 of the sixth embodiment as well, the deploying force τx can be adjusted by adjusting the initial displacement x of the first spring 650 with the pressing force adjustment screw 660, adjusting or controlling the position of the operating member 648 in the vertical direction, or adjusting pressing force adjustment screws provided on the second springs 651 and 652 and the like in the same manner as the previously described fifth embodiment.

### (Seventh Embodiment)

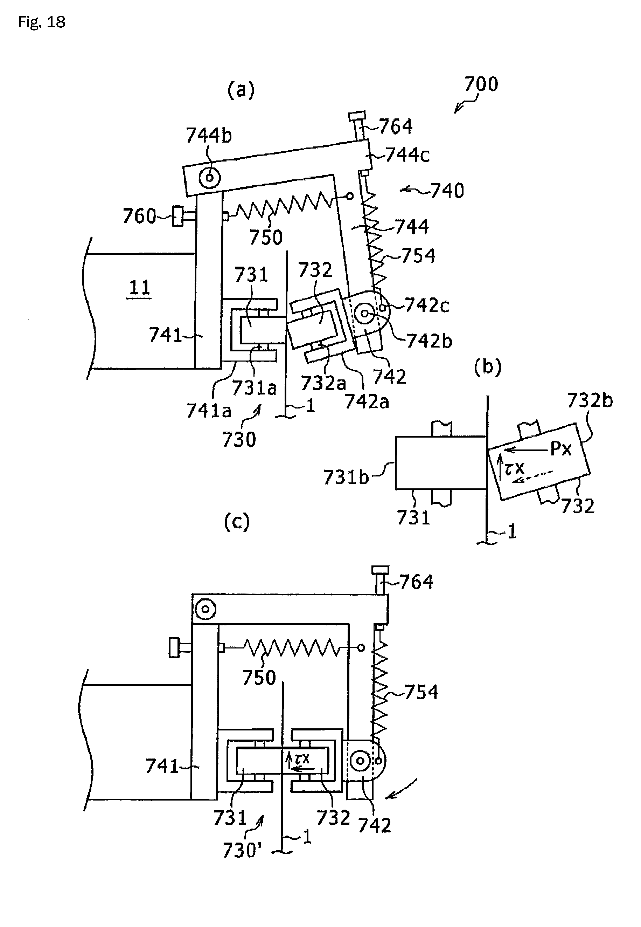

Next, FIG. 18 consists of front views as viewed from the upstream side in the direction of transport showing a substrate position control device 700 according to a seventh embodiment of the present invention, with FIGS. 18A and 18B showing a state in which pressing by a pair of clamping rollers 730 has begun, and FIG. 18C showing a state in which deploying force is applied. The pair of clamping rollers 730 of the substrate position control device 700 of the seventh embodiment is composed of a stationary roller 731 and a movable roller 732, and although both of the clamping rollers 730 in the example shown in the drawings are cylindrical rollers, one or both can also be tapered rollers.

The movable roller 732 is rotatably and unmovably supported in the axial direction by a support 742a on the distal end of a second link 742 through a shaft 732a. The second link 742 is pivotably supported by the distal end of a first link 744 at a hinge 742b at an intermediate location thereof, and a return spring 752, which urges the movable roller 732 downward in the drawings in the opposite direction from the direction in which the flexible substrate 1 is deployed, is interposed between another end 742c of the second link 742 beyond the hinge 742b and an extending portion 744c of the first link 744. Urging force (restoring force) of the return spring 752 can be adjusted with an adjustment screw 764 screwed into the extending portion 744c.

The first link 744 is bent into an L-shape at an intermediate portion thereof, is pivotably supported on the upper end of a stationary side support member 741 at a hinge 744b on the upper end thereof, and is urged in a direction that approaches the stationary side support member 741 by a first spring 750 (pressure spring) interposed between the first link 744 and the stationary side support member 741 through a pressing force adjustment screw 760.

According to the configuration described above, in the substrate position control device 700 of the seventh embodiment, in the state in which the pair of clamping rollers 730 begin pressing from a released state in which they are mutually separated, as shown in FIG. 18A, as a result of urging by the return spring 752, the second link 742 is angularly displaced to a location where a corner of the support 742a contacts or approaches the inside of the first link 744, the movable roller 732 contacts a peripheral surface 731b of the stationary roller 731 in an inclined state, and the flexible substrate 1 is clamped there between.

While in this state, when the movable roller 732 is pressed against the stationary roller 731 at a prescribed pressing force Px by the first spring 750, rotational force centering about the hinge 742b of the second link 742 is generated in the movable roller 732 as shown in FIG. 18B such that angular displacement is canceled in opposition to urging force of the return spring 752, this rotational force acts as the deploying force τx (shearing force) acting upward in the drawings along the clamping surface of the flexible substrate 1, and the upper edge of the flexible substrate 1 is deployed by the deploying force τx.

Thus, in the substrate position control device 700 of the seventh embodiment, since the deploying force τx applied to the upper edge of the flexible substrate 1 is proportional to the difference between the pressing force Px of the first spring 750 and the restoring force of the return spring 752, the deploying force τx can be adjusted by adjusting the pressing force Px of the pair of clamping rollers 730 by adjusting the initial displacement x of the first spring 750 with the pressing force adjustment screw 760 and/or adjusting the restoring force of the return spring 752 with the adjustment screw 764.

### (Eighth Embodiment)

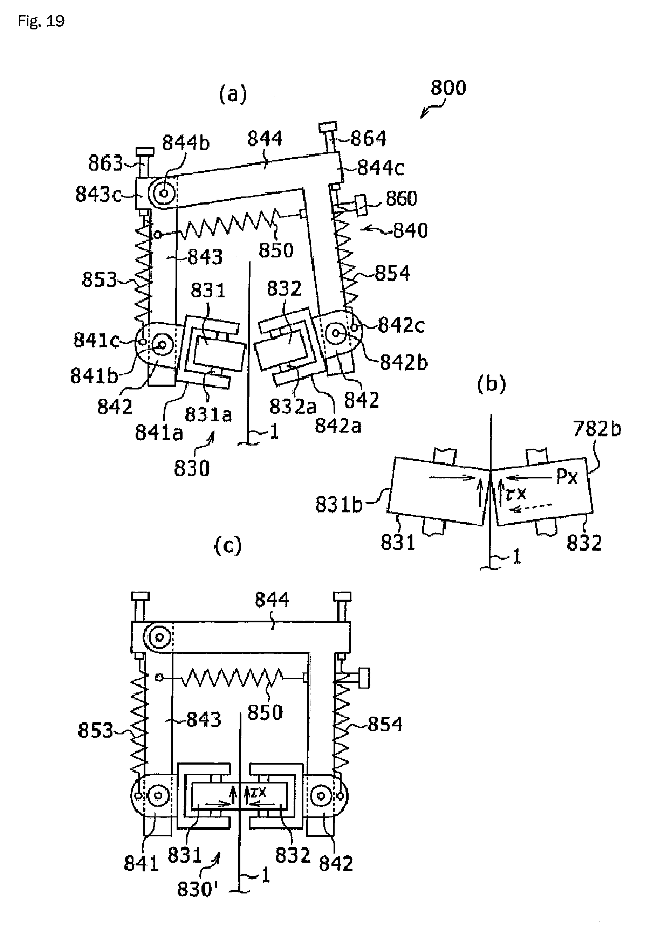

Next, FIG. 19 consists of front views as viewed from the upstream side in the direction of transport showing a substrate position control device 800 according to an eighth embodiment of the present invention, with FIGS. 19A showing a state in which a pair of clamping rollers 830 are released, FIG. 19B showing a state in which pressing force is applied by the pair of clamping rollers 830, and FIG. 19C showing a state in which deploying force is applied. In contrast to the stationary roller (731) being stationarily supported by the stationary side support member (741) in the above-mentioned seventh embodiment, in the substrate position control device 800 of the eighth embodiment, a stationary roller 831 is supported by a stationary side support member 843 through a second link 841, and together with being able to pivot on a limited basis in the direction of deployment of the flexible substrate 1, the second link 841 on the stationary side has a return spring 853 accompanied by an adjustment screw 863 interposed between another end 841c beyond a hinge 841b and an extending portion 843c of the stationary side support member 843 in the same manner as a movable side second link 842.

According to the configuration described above, in the substrate position control device 800 of the eighth embodiment, when in the released state in which the pair of clamping rollers 830 is mutually separated, as shown in FIG. 19A, as a result of urging by return springs 853 and 854, each of the second links 841 and 842 are angularly displaced to locations where corners of supports 841a and 842a contact the inside of the stationary side support member 843 or a first link 844.

When a movable roller 832 is pressed against the stationary roller 831 with a prescribed pressing force Px applied by a first spring 850 from this released state, as shown in FIG. 19B, the stationary roller 831 and the movable roller 832 first make contact in a state in which are both are inclined, the flexible substrate 1 is clamped at the upper end of each peripheral surface 831b and 832b, rotational force centering about hinges 841b and 842b of the second links 841 and 842 is respectively generated in the stationary roller 831 and the movable roller 832 such that angular displacement is canceled in opposition to urging force of the return springs 853 and 854, this rotational force acts as the deploying force τx applied upward in the drawings along the clamping surface of the flexible substrate 1, and the upper edge of the flexible substrate 1 is deployed by this deploying force τx.

Thus, in the substrate position control device 800 of the eighth embodiment, the deploying force τx acting on the upper edge of the flexible substrate 1 is accompanied by an action that causes the clamping surface per se to move upward. Adjustment of the deploying force τx can be carried out by adjusting the initial displacement x of the first spring 850 with a pressing force adjustment screw 860 and/or adjusting the return springs 853 and 854 with the adjustment screws 863 and 864 as previously described.

### (Ninth Embodiment)

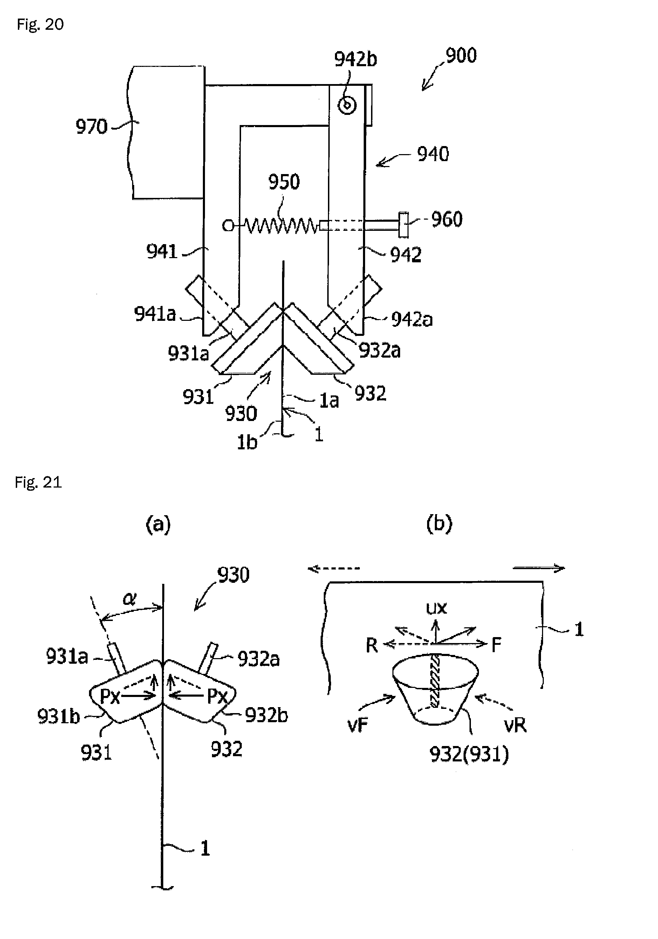

Next, FIG. 20 is a front view as viewed from the upstream side in the direction of transport showing a substrate position control device 900 of a ninth embodiment of the present invention. Rollers 931 and 932 that compose a pair of clamping rollers 930 of the substrate position control device 900 of the ninth embodiment are both tapered rollers having peripheral surfaces 931b and 932b inclined relative to the axial direction, and one of the clamping rollers is a stationary roller 931 while the other is a movable roller 932. When in an operating state, each of the clamping rollers 931 and 932 are held on the distal end of a stationary side support member 941 and a movable side support member 942 so that the inclined peripheral surfaces 931b and 932b are mutually pressed together with the flexible substrate 1 positioned there between, and such that respective shafts 931a and 932a have an inclination corresponding to the peripheral surfaces 931b and 932b relative to the transport surface (flexible substrate 1). In the example shown in the drawing, each of the rollers 931 and 932 are arranged such that the stationary roller 931 contacts the back side of the flexible substrate 1, while the movable roller 932 contacts the front side.

Each of the rollers 931 and 932 are formed with, for example, metal, ceramic or plastic, or are composed by adhering an elastic material such as rubber to the periphery of a core formed with these materials, and are respectively rotatably supported by shafts 931a and 932a (support shafts) through bearings able to bear thrust loading. Each of the shafts 931a and 932a are immobilized with removable fastening means such as screws not shown in a state in which they are inserted into retaining portions 941a and 942a (retaining holes, retaining grooves or chucks) formed in each of the support members 941 and 942, and their respective positions in the axial direction are preferably able to be adjusted. Alternatively, each of the clamping rollers 931 and 932 may be immobilized by each of the shafts 931a and 932a (rotating shafts), and each of the shafts 931a and 932a may be rotatably supported by respective supports (941a, 942a) through bearings able to bear thrust loading as was previously described in other embodiments.

The stationary side support member 941 is fixed to a structural element 11 of a vacuum chamber through a mounting bracket 970. The movable side support member 942 is pivotably supported by an extending portion extending from the upper end of the stationary side support member 941 through a hinge 942b, and the movable roller 932 is able to contact and separate from the stationary roller 931 by pivoting of the movable side support member 942 centering about a hinge shaft (942).

Moreover, a spring 950 is interposed as urging means between intermediate portions of the stationary side support member 941 and the movable side support member 942. One end of the spring 950 is connected to the movable side support member 942 through a pressing force adjustment screw 960, and pressing force (contact pressure) of the movable roller 932 on the stationary roller 931 can be adjusted by adjusting the initial displacement of the spring 950 by turning the pressing force adjustment screw 960.

In the substrate position control device 900 composed in the manner described above, each of the clamping rollers 931 and 932 has a different circumferential length at a large diameter side and a small diameter side. As a result, as shown in FIG. 21B, when each of the clamping rollers 931 and 932 are driven and rotated by contact with the flexible substrate 1 moving in a transport direction F (R), although clockwise rotational force vF (vR) is generated within the contact surface (clamping surface), since the flexible substrate 1 is linearly transported by feed rollers not shown in a state in which a prescribed tension is applied, only a force component ux (deploying force) acting in a direction perpendicular to the rotational force vF (vR) is transmitted to the contact surface of the flexible substrate 1, and the upper edge of the flexible substrate 1 is deployed upward by this upward deploying force ux.

The deploying force ux transmitted to the flexible substrate 1 by each of the clamping rollers 931 and 932 described above is proportional to the pressing force Px applied by each of the clamping rollers 931 and 932, and although the deploying force ux corresponding to an inclination angle α is transmitted according to the shape of each of the clamping rollers 931 and 932 as the pressing force Px becomes larger, in the case the pressing force Px is small, sliding occurs predominantly within the contact surface and the transmitted deploying force ux decreases. Since the pressing force Px applied by each of the clamping rollers 931 and 932 is proportional to elastic displacement of the spring 950, the deploying force ux acting on the upper edge of the flexible substrate 1 can be adjusted by adjusting the initial displacement of the spring 950 by turning the pressing force adjustment screw 960, and since this deploying force ux is a lifting force that raises the upper edge of the flexible substrate 1 in opposition to its own weight, the position of the upper edge of the flexible substrate 1 can be adjusted.

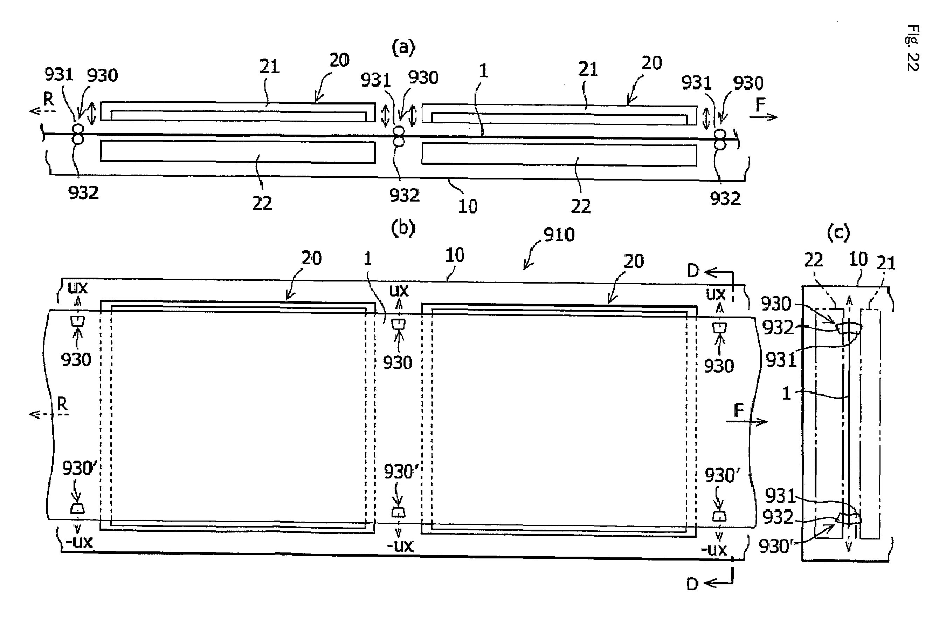

FIGS. 22A to 22C indicate an embodiment in which the substrate position control device 900 (930, 930') of the ninth embodiment described above is applied to a stepwise deposition type of production device 910 similar to that shown in FIG. 1. As was previously described, a large number of deposition units 20 are arranged in a row along the transport direction F (R) within the common vacuum chamber 10. Substrate position control devices (930, 930') are composed of pairs of clamping rollers 930 and 930' arranged on each of the upper and lower sides of a transport path between each of the deposition units 20, and the lower pair of clamping rollers 930' are installed by vertically inverting the same structure as the upper pair of clamping rollers 930.

According to the above-mentioned configuration, the flexible substrate 1 can be deployed in the vertical direction of width and thermal wrinkling as well as tension wrinkling of the flexible substrate 1 caused by transport tension can be inhibited by allowing deploying force -ux acting downward on the lower edge of the flexible substrate 1 applied by the lower pair of clamping rollers 930' to act simultaneous to deploying force ux acting upward on the upper edge of the flexible substrate 1 applied by the upper pair of clamping rollers 930 at the same location relative to the transport direction F (R) between each of the deposition units 20. In addition, since the difference between the deploying forces ux and -ux of each of the upper and lower pairs of clamping rollers 930 and 930' results in a force that lifts the flexible substrate 1 in opposition to its own weight, the transport height of the flexible substrate 1 can be maintained constant by controlling the pressing force of the upper pair of clamping rollers 930 corresponding to the position in the vertical direction of the flexible substrate 1.

Moreover, since deploying action acting in the vertical direction of width on the flexible substrate 1 applied by the pairs of clamping rollers 930 and 930' acts in the same manner in either of the transport directions F and R of the flexible substrate 1, and control of the position of the flexible substrate 1 in the vertical direction can also be carried out in the same manner for either of the transport directions F and R of the flexible substrate 1, this configuration offers the advantage of being able to immediately accommodate deposition processes that include transport of the flexible substrate 1 in both the forward and reverse directions.

Furthermore, deploying action on the flexible substrate 1 and position control of the flexible substrate 1 as previously described are not dependent on the direction of pressing of each of the pairs of clamping rollers 931 and 932 provided the peripheral surfaces of each of the clamping rollers 931 and 932 do not make contact at only the large diameter side or small diameter side, and the pressing force contains a component that is perpendicular to the clamping surface. Thus, deploying action similar to that of the above-mentioned ninth embodiment is also obtained in the previously described substrate position control device 200 of the second embodiment (clamping rollers 231 and 232) and the substrate position control device 400 of the fourth embodiment (clamping rollers 431 and 432).

Although an example of the case in which initial displacement of the spring 950 is preliminarily adjusted with the adjustment screw 960 was indicated in the above-mentioned embodiment, as in each of the embodiments to be subsequently described, a substrate position control device can also be configured that is able of active control of the initial displacement (pressing force) of the spring 950 using a driving device (actuator or drive transmission mechanism thereof).

### (Application Example of Ninth Embodiment)

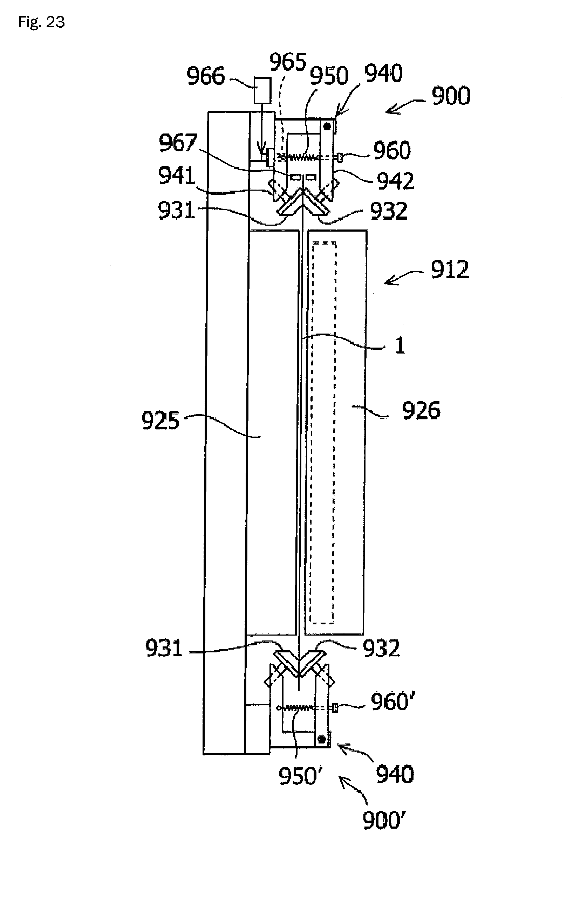

FIG. 23 is a cross-sectional view as viewed from the upstream side in the direction of transport showing an embodiment in which the substrate position control device 900 according to the ninth embodiment of the present invention as previously described is applied to a continuous deposition type of production device 912. The production device 912 is provided with an electrode 925 (target) and a ground electrode 926 arranged in opposition on both sides of the flexible substrate 1 with the flexible substrate 1 interposed there between within a vacuum chamber maintained at a prescribed degree of vacuum in the same manner as the production device 112 shown in FIGS. 6 and 7. In this embodiment, the lower substrate position control device 900' is composed in the form of a preset type in which the initial displacement of a spring 950' is preliminarily adjusted with an adjustment screw 960', while the upper substrate position control device 900 is provided with an actuator 966 and a sensor 967, and is composed to enable active control of pressing force applied by the spring 950.

In FIG. 23, although one end of the spring 950 of the upper substrate position control device 900 is connected to the movable side support member 942 through the pressing force adjustment screw 960 in the same manner as previously described, the other end is connected to a movable shaft 965 supported so as to be able to be displaced forward and backward by the stationary side support member 941 instead of being connected to the stationary side support member 941. The movable shaft 965 is supported by the stationary side support member 941 through a feed screw mechanism, and is composed so as to be driven forward and backward by the schematically shown actuator 966.

A known type of actuator such as a hydrostatic pressure actuator or electromagnetic actuator can be used for the actuator 966. However, since the inside of the vacuum chamber is exposed to reduced pressure and high temperatures, the actuator 966 is preferably provided outside the vacuum chamber, and the movable shaft 965 is preferably driven remotely through a drive transmission mechanism such as a push or pull rod, lever, link or feed screw mechanism.

Moreover, the substrate position control device 900 is provided with the sensor 967 that detects the position of the upper end of the flexible substrate 1 either in proximity to the clamping rollers 931 and 932 or at a distance away on the upstream side or downstream side in the direction of transport, and the sensor 967 is connected to a control device (not shown) of the actuator 966. There are no particular limitations on the type of the sensor 967, and various known types of sensors can be used.

For example, the sensor 967 can be configured to include two detection units (such as optical sensors) adjacently arranged above and below corresponding to an upper limit value and lower limit value of the upper end position of the flexible substrate 1, and (i) determines that the upper end position of the flexible substrate 1 is equal to or greater than the upper limit in the case the flexible substrate 1 is detected by both upper and lower detection units, (ii) determines that the upper end position of the flexible substrate 1 is below the lower limit in the case the flexible substrate 1 is not detected by both the upper and lower detection units, or (iii) determines that the upper end position of the flexible substrate 1 is within the proper range in the case the flexible substrate 1 is only detected by the lower detection unit. Alternatively, the sensor 967 may also be composed to include a single image sensor, and detect the upper end position of the flexible substrate 1 by image processing.

In the case of (i) in which the upper end position of the flexible substrate 1 has been determined to be equal to or greater than the upper limit, the movable shaft 965 is advanced by driving of the actuator 966, and if pressing force of the clamping rollers 931 and 932 applied by the spring 950 is decreased, deploying force (ux) acting upward on the upper edge of the flexible substrate 1 through the clamping rollers 931 and 932 decreases, deploying force (-ux) acting downward on the lower edge of the flexible substrate 1 through the clamping rollers 931 and 932 of the lower substrate position control device 900' becomes dominant, and the flexible substrate 1 is induced downward.

Conversely, in the case of (ii) in which the upper end position of the flexible substrate 1 is below the lower limit, the movable shaft 965 is withdrawn by driving of the actuator 966, and if pressing force of the clamping rollers 931 and 932 applied by the spring 950 is increased, deploying force (ux) acting upward on the upper edge of the flexible substrate 1 through the clamping rollers 931 and 932 increases, deploying force (ux) acting upward becomes dominant to deploying force (-ux) applied downward by the clamping rollers 931 and 932 of the lower substrate position control device 900', and the flexible substrate 1 is induced upward.

In this manner, the upper end position of the flexible substrate 1 can be maintained within a proper range by feedback control of the pressing force of the clamping rollers 931 and 932 applied by the spring 950 of the upper substrate position control device 900 by using the sensor 967, the actuator 966 and a control device. Furthermore, the mechanism that controls pressing force applied by the spring 950 is not limited to that described above, but rather other mechanisms can be used that are able to control the initial displacement of the spring 950.

In addition, instead of controlling the initial displacement of the spring 950, a configuration can be employed such that a second spring is provided that urges the movable side support member 942 in the same direction (or opposite direction) of the spring 950 (first spring) , and pressing force of the clamping controllers 931 and 932 is controlled by advancing and withdrawing the second spring with an actuator.

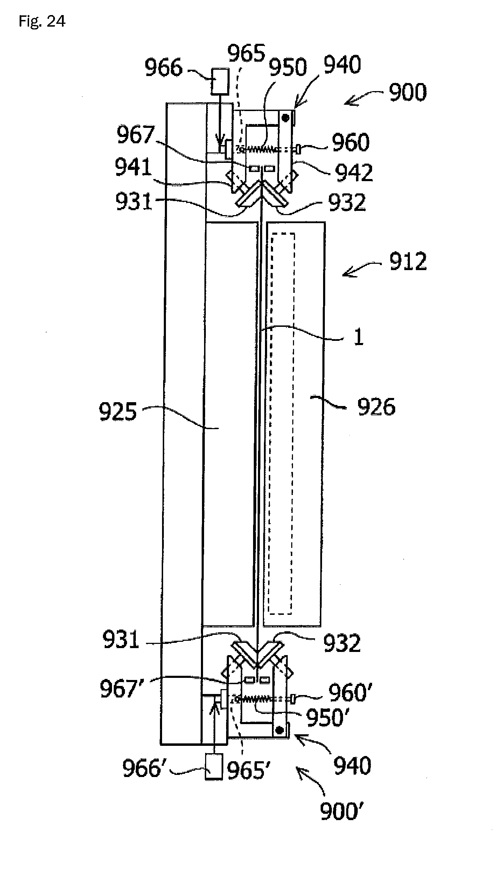

Although the case of providing the actuator 966 only in the upper substrate control position device 900 and using a preset type for the lower substrate position control device 900' is indicated in the above-mentioned embodiment, actuators 966 and 966' and sensors 967 and 967' can be provided in each of the upper and lower substrate position control devices 900 and 900' as shown in FIG. 24, and by controlling these devices with a common control device, the upper end position and lower end position of the flexible substrate 1 can be actively controlled, and both the position of the flexible substrate 1 in the vertical direction of width (height direction) and the degree of deployment in the direction of width can be actively controlled. However, in consideration of the effect of gravity acting on the flexible substrate 1, it is necessary that the initial displacement and control quantity of the springs on the each of the upper and lower slides in each of the upper and lower substrate position control devices 900 and 900' be set separately for the upper and lower sides.

In addition, although the above-mentioned embodiment describes the case of configuring a substrate position control device enabling active control of the initial displacement (pressing force) of the spring 950 in the continuous deposition type of production device 912, a substrate position control device can be similarly configured for the stepwise deposition type of production device 910 shown in FIG. 22. However, in the stepwise deposition type of production device 910, position detection and position control of the flexible substrate 1 can be carried out intermittently in synchronization with stepwise transport.

Namely, following a single transport step, position detection of the upper end or both upper and lower ends of the flexible substrate 1 is carried out by the sensor 967 during stoppage of stepwise transport in which a single step of a deposition process is carried out, and in the case displacement of the flexible substrate 1 has been detected by the sensor 967, a control signal based on that detection is output to the actuator 966, and initial displacement (pressing force) of the spring 950 is corrected by the actuator 966. At this time, since the flexible substrate 1 is stopped, only the pressing force of the clamping rollers 931 and 932 changes, and the flexible substrate 1 does not move in the vertical direction.

Next, when a single step of the deposition process has been completed and transport in the next step is carried out on the flexible substrate 1, the flexible substrate 1 is inducted upward or downward by the clamping rollers 931 and 932 for which pressing force has been corrected, and the position thereof in the vertical direction is corrected. Thus, in this type of control, position detection and position correction of the flexible substrate 1 are basically carried out in an alternating manner.

In addition, in the stepwise deposition type of production device 910 as well, simultaneous to the sensor 967 carrying out position detection during transport of the flexible substrate 1 in each step, the initial displacement (pressing force) of the spring 950 is corrected by the actuator 966, thereby enabling position control of the flexible substrate 1 to be carried out in real time while also enabling these two types of control to be used in combination.

Although each of the above-mentioned embodiments describes the case of carrying out of applying the substrate position control device according to the present invention to the production device 912 that carries out deposition processing while transporting the flexible substrate 1 in the horizontal direction and in a vertical orientation, the substrate position control device according to the present invention can also be applied to various processing devices or production devices that carry out processing such as deposition while transporting the flexible substrate 1 in the horizontal direction or vertical direction and in a horizontal orientation (level orientation).

### (Tenth Embodiment)

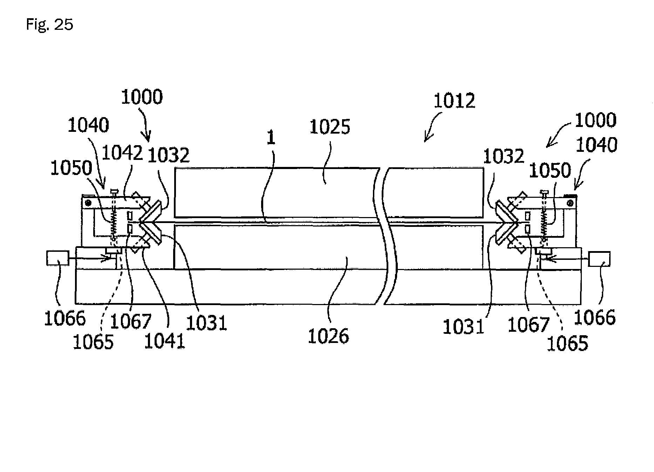

FIG. 25 is a cross-sectional view as viewed from the upstream side in the direction of transport showing an embodiment in which a substrate position control device 1000 similar to the ninth embodiment of the present invention is applied to a continuous deposition type of production device 1012 that transport in a horizontal orientation. The production device 1012 is provided with deposition units composed of an electrode 1025 (target) and a ground electrode 1026 arranged in opposition above and below the flexible substrate 1 with the flexible substrate 1 interposed there between, and the deposition units are arranged within a vacuum chamber maintained at a prescribed degree of vacuum. Guide rollers (idle rollers), feed rollers and tension rollers that compose transport means are arranged on the upstream sides and downstream sides of the deposition units in the direction of transport, and unwinding rollers and winding rollers of the flexible substrate 1 are arranged on the upstream side and downstream side thereof in the direction of transport. Since the configurations thereof are the same as those of the prior art, they are not shown in the drawings.

In FIG. 25, the substrate position control device of the production device 1012 is composed of two substrate position control devices 1000 arranged on both sides in the direction of width of the transport path of the flexible substrate 1, the two substrate position control devices 1000 basically have the same configuration as the substrate position control device 900 of the ninth embodiment with the exception of being arranged horizontally with a stationary side clamping roller 1031 (stationary side support member 1041) being on the bottom, both are provided with an actuator 1066 and a sensor 1067, and are composed to enable active control of pressing force by a spring 1050.

In this production device 1012, the ground electrode 1026 is arranged on the side of the lower surface of the flexible substrate 1, there is little effect of the weight of the flexible substrate 1, and this is similar for the substrate position control devices 1000 on each side. Thus, the initial displacements of the springs 1050 and the control quantity of each actuator 1066 are basically set to be equal for the substrate position control devices 1000 on each side.

On the other hand, control of pressing force applied by each of the actuators 1066 is carried out individually and in coordination by each control device based on detection by each of the sensors 1067 in order to correct displacement and snaking in the direction of width of the flexible substrate 1 while deploying the flexible substrate 1 in the direction of width. Thus, the sensor 1067 on each side is preferably respectively provided with two detection units adjacently arranged in the direction of width corresponding to maximum and minimum values allowed for the position of each edge of the flexible substrate 1, or alternatively, the sensor 1067 on each side is preferably composed of a single image sensor and composed so that the position of each edge of the flexible substrate 1 is detected by image processing.

Although the above has provided a description of embodiments of the present invention, the present invention is not limited to the above-mentioned embodiments, but rather can be altered or modified in various ways based on the technical idea of the present invention.

For example, although the case of using a tension spring as urging means was indicated in each of the above-mentioned embodiments, the urging means can also be installed as a compression spring by suitably altering each of the support members on the stationary side and movable side and the connecting points to each of the links and movable shafts. In this case, an arm and the like may be added to the support members on the stationary side and movable side or each of the links and movable shafts as necessary. In addition, a coil spring may be changed to various known types of springs such as a spiral spring, torsion spring or leaf spring. Although the form of mutual contact and separation by each of the support members on the stationary side and movable side and each of the links can be substituted with linear sliding, pivoting (cantilever rotation) is preferable in terms of efficiency.

In addition, although the case of applying the substrate position control device according to the present invention to a production device of thin film laminates for a solar cell is described in each of the above-mentioned embodiments, the substrate position control device according to the present invention can also naturally be applied to a production device of semiconductor thin films for organic EL devices and the like as well as various other types of processing devices requiring position control and deployment of flexible substrates other than deposition, including coating, cleaning, drying, heat treatment and surface processing.

### EXPLANATION OF REFERENCE NUMERALS

1 Flexible substrate
10 Vacuum chamber
11 Structural element
20 Deposition unit
21, 25, 925, 1025 Electrode
22, 26, 926, 1026 Ground electrode
24 Deposition unit
27 Support roller
100, 200, 202, 203, 300, 400, 500, 600, 700, 800, 900, 1000 Substrate position control device
130, 230, 330, 430, 530, 630, 730, 830, 930 Pair of clamping rollers
131, 231, 331, 531, 731, 831, 931, 1031 Stationary roller
132, 232, 332, 431, 432, 532, 631, 632, 732, 832, 932, 1032 Movable roller
140, 240, 340, 540, 640, 740, 840, 940, 1040 Support mechanism
141, 241, 341, 541, 741, 843, 943, 1041 Stationary side support member
142, 242, 342, 441, 442, 942, 1042 Movable side support member 150, 250, 350, 450, 950, 1050 Spring (urging means)
160, 260, 360, 460, 560, 660, 760, 860, 960 Pressing force adjustment screw
542, 641, 642, 742, 841, 842 Second spring
544, 643, 644, 744, 844 First spring
546, 645, 646 Third spring
550, 650, 750, 850 Fist spring (pressure spring)
552, 651, 652 Second spring (deploying spring)
544a, 643a, 644a Stopper
754, 853, 854 Return spring
764, 863, 864 Adjustment screw
965, 1065 Movable shaft
966, 1066 Actuator
967, 1067 Sensor

## Claims

1. A flexible substrate position control device in a processing device that transports a band-shaped flexible substrate in a horizontal direction and in a vertical orientation while carrying out processing of the substrate by processing units installed in a transport path of the substrate,
the control device comprising:
a pair of clamping rollers that clamp an upper edge of the substrate;
a support mechanism that rotatably supports the pair of clamping rollers while allowing these rollers to mutually contact and separate from each other;
urging means for applying pressing force to the pair of clamping rollers through the support mechanism; and
adjusting means for adjusting the pressing force applied by the urging means, wherein
the pair of clamping rollers has an inclination, in which the direction of pressing relative to a clamping surface of the substrate is towards the edge of the substrate in the direction of width, and is supported by the support mechanism such that rotating direction at the clamping surface is the same direction as the transport direction of the substrate.

2. A flexible substrate position control device in a processing device that transports a band-shaped flexible substrate in a horizontal direction and in a vertical orientation while carrying out processing of the substrate by processing units installed in a transport path of the substrate,
the control device comprising:
a support mechanism that rotatably supports the pair of clamping rollers while allowing these rollers to mutually contact and separate from each other;
urging means for applying pressing force to the pair of clamping rollers through the support mechanism; and
adjusting means for adjusting the pressing force applied by the urging means, wherein
the pair of clamping rollers have an inclination, in which their respective axial directions move away relative to a clamping surface of the substrate towards an edge of the substrate in a width direction thereof, and are supported by the support mechanism such that the rotating direction at the clamping surface is the same direction as the transport direction of the substrate.

3. The flexible substrate position control device according to claim 1, wherein respective peripheral surfaces of the rollers that compose the pair of clamping rollers have an arc-shaped cross-section, and the rollers are supported by the support mechanism so as to be able to contact and separate from each other while being offset in the axial direction.

4. The flexible substrate position control device according to claim 1, wherein at least one of the rollers that compose the pair of clamping rollers is a tapered roller having a peripheral surface inclined in the axial direction thereof.

5. The flexible substrate position control device according to claim 2, wherein each of the rollers that compose the pair of clamping rollers is a tapered roller having a peripheral surface inclined in the axial direction thereof.

6. The substrate position control device of a thin film laminate production device according to claim 5, wherein the pair of clamping rollers is supported by the support mechanism so that the clamping surface has an inclination relative to the direction of width of the substrate.

7. The flexible substrate position control device according to claim 1 or claim 2, wherein the support mechanism includes a first link that enables one or both of the pair of clamping rollers to move in a direction of mutual contact and separation, and a second link that enables the clamping rollers to move in the direction of width of the substrate, the urging means includes a first urging member that urges the first link in a direction in which the clamping rollers are pressed together, and a second urging member that urges the second link in a deploying direction towards the edge of the substrate in the width direction, and the pressing force adjusting means includes urging force adjusting means of the second urging member.

8. The flexible substrate position control device according to claim 7, wherein the support mechanism further includes a third link that enables a support point of the first link to move in the direction of width of the substrate.

9. The flexible substrate position control device according to claim 1 or claim 2, wherein the support mechanism includes a first link that enables one or both of the pair of clamping rollers to move in a direction in which these rollers mutually contact and separate from each other, a second link that pivotably supports one or both of the pair of clamping rollers in the direction of width of the substrate, and a return spring that urges one or both of the clamping rollers in a direction opposite to the edge of the substrate in the width direction through the second link, and the urging means includes a first urging member that urges the first link in the direction of contact and separation of the clamping rollers, while one or both of the clamping rollers is composed so as to be pressed at a pivot angle at which pressing force by the first urging member and restoring force by the return spring are in equilibrium.

10. The flexible substrate position control device according to claim 1 or claim 2, further comprising a pair of lower clamping rollers that clamp the lower edge of the substrate, and a support mechanism and urging means for the pair of lower clamping rollers that are composed in the same manner as the support mechanism and the urging means.

11. The flexible substrate position control device according to claim 10, wherein the processing device is a thin film laminate production device that is provided with a plurality of deposition units serving as processing units arranged in a row at an equal pitch along the transport path of the substrate and that sequentially laminates and forms thin films on the surface of the substrate successively while intermittently transporting the substrate at a pitch corresponding to the deposition units, and the pair of upper clamping rollers and the pair of lower clamping rollers are arranged between the plurality of deposition units.

12. The flexible substrate position control device according to claim 10, wherein the processing device is a thin film laminate production device that laminates and forms thin films on the surface of the substrate at deposition units serving as the processing units while continuously transporting the substrate, and a plurality of the pairs of upper clamping rollers and a plurality of the pairs of lower clamping rollers are arranged along the transport direction above and below the deposition units.

13. The flexible substrate position control device according to claim 12, further comprising a plurality of support rollers arranged along the transport direction in which the substrate is supported, respectively, between a thin film formation region of the substrate and the plurality of pairs of upper clamping rollers and between the thin film formation region and the plurality of pairs of lower clamping rollers.

14. A flexible substrate position control device in a processing device that transports a band-shaped flexible substrate and carries out processing of the substrate by processing units installed in a transport path of the substrate,
the control device comprising:
respective pairs of clamping rollers that clamp each edge of the substrate;
respective support mechanisms that rotatably support each of the pairs of clamping rollers while respectively allowing each of the pairs to contact and separate from each other;
urging means for applying pressing force to each of the pair of clamping rollers through each of the support mechanisms; and
adjusting means for adjusting the pressing force applied by the urging means, wherein
each of the pairs of clamping rollers has an inclination, in which each of the axial directions thereof moves away toward an edge of the substrate in the width direction relative to a holding surface of the substrate, and are supported by each of the support mechanisms so that the rotating direction at the clamping surface is the same direction as the transport direction of the substrate.

15. The flexible substrate position control device according to claim 14, wherein each roller that composes each of the pairs of clamping rollers is a tapered roller having a peripheral surface inclined relative to the axial direction thereof.
